# EUROPEAN PATENT SPECIFICATION

(11) **EP 4 060 405 B1**
(45) Date of publication and mention of the grant of the patent: **27.11.2024**
(21) Application number: 20887168.1
(22) Date of filing: 30.10.2020
(51) Int. Cl.: H04N 23/45, H04N 23/90, G06F 1/16, H04M 1/02, G03B 11/00, H04N 7/14

(54) **ELECTRONIC DEVICE**
ELEKTRONISCHE VORRICHTUNG
DISPOSITIF ÉLECTRONIQUE

(30) Priority: 12.11.2019 JP 2019204844
(43) Date of publication of application: 21.09.2022
(73) Proprietor: Sony Semiconductor Solutions Corporation, Atsugi-shi Kanagawa 243-0014 (JP)
(72) Inventor: NAKATA Masashi, Atsugi-shi, Kanagawa 243-0014 (JP); KANAI Junichi, Atsugi-shi, Kanagawa 243-0014 (JP)
(74) Representative: Müller Hoffmann & Partner
(86) International application number: PCT/JP2020/040954
(87) International publication number: WO 2021/095581

(56) References cited:
- EP-A1- 2 424 220
- WO-A1-2007/013272
- CN-A- 110 336 907
- JP-A- 2006 060 535
- JP-A- 2014 138 290
- JP-A- 2016 136 246
- US-A1- 2012 050 601
- US-A1- 2015 049 165
- US-A1- 2018 198 980
- US-A1- 2022 191 350

## Description

### [Technical Field]

The present disclosure relates to an electronic apparatus.

### [Background Art]

A recent electronic apparatus, such as a smartphone, a cellular phone, and a PC (Personal Computer), has a camera equipped on a bezel of a display unit and allowing easy video calling and video capturing. A smartphone or a cellular phone is often carried in a pocket or a bag. Accordingly, an external size of the smartphone or the cellular phone needs to be reduced to a smallest possible size. On the other hand, when a display screen has a small size, characters to be displayed become smaller in size and more difficult to visually recognize as display resolution increases. Accordingly, it has been studied to reduce a bezel width disposed around the display screen to increase the size of the display screen as much as possible without increasing the external size of the electronic apparatus.

However, a camera or the like is often equipped on the bezel of the electronic apparatus. In this case, it is difficult to reduce the bezel width to a size smaller than an outside diameter size of the camera. Moreover, in a case where the camera is disposed on the bezel, since a visual line is often positioned in the vicinity of the center of the display screen during conversation through video calling, for example, the visual line deviates from an optical axis of the camera, and a captured image becomes unnatural due to deviation of the visual line.

For avoiding the problems described above, it has been proposed to arrange a camera module on the side opposite to a display surface of the display unit and capture, using the camera, an image of object light having passed through the display unit.

Documents CN 110 336 907 A and US 2022/191350 A1 disclose a terminal including a shell, a first camera module, a second camera module, and a display panel. The shell includes a base plate and a side plate thereon. The first camera module and second camera module are located in a storage space formed by the base place and the side plate. The display panel is a transparent display panel having a transparent portion corresponding to the first camera module and second camera module. The first camera module obtains a light signal having a wavelength within a first wave band, the second camera module obtains a light signal having a wavelength within a first wave band, and a minimum wavelength of the second wave band is greater than a maximum wavelength of the first wave band.

Document US 2015/049165 A1 discloses an apparatus for an eye contact video call capable of a realistic call in eye contact with the other party. A transparent display is formed at a central part of the opaque display and a camera is formed at a rear side thereof, thereby allowing a realistic call in eye contact with the other party and at the same time, the readability to be improved even in cases of a usual display use (mode). Further, the manufacturing cost of a terminal may be reduced and an interference of an output video of a transparent display that exists in the camera photograph video may also be effectively eliminated.

Document EP 2 424 220 A1 discloses an image processing apparatus including: an image obtaining section obtaining an input image; a first image processing section generating a predetermined quality image resulting from rendering the input image in high image quality using a predetermined image processing parameter; a display section displaying the predetermined quality image; a characteristic region identifying section identifying a plurality of characteristic regions in the input image; a parameter determining section determining, respectively for the plurality of characteristic regions, image processing parameters for rendering images of the plurality of characteristic regions, in higher image quality; a second image processing section generating a plurality of high quality characteristic-region images respectively of the plurality of characteristic regions, using the image processing parameters determined by the parameter determining section; and a display control section replacing the plurality of characteristic regions in the predetermined quality image under display, with the plurality of high quality characteristic-region images.

Document US 2018/198980 A1 discloses a display including an array of display pixels. Each display pixel includes at least one light-emitting diode. At least one of the display pixels includes an image sensor.

Document WO 2007/013272 A1 discloses a display device including a liquid crystal display panel and an imaging unit having an image forming optical system. The imaging unit is arranged in such a manner that a reflected light from an object on a display region of the liquid crystal panel comes into the image forming optical system via the liquid crystal panel. The imaging unit receives the incident reflected light and images the object. It is preferable that the display device further include a detection light source for applying a detection light to the object. In this display device, an image can be displayed by using the display panel. Accordingly, it is possible to reduce heat generation, noise, and size. Furthermore, according to the display device in which the imaging unit includes the image forming optical system, it is possible to acquire an image with a high resolution as compared to a display device having the conventional input function. The display device includes an input function and can be used as a display device of a personal computer, a television, and a game device.

JP 2016 136246 A discloses a display device including a display panel which has a first polarizer having a first polarization axis substantially parallel to a first direction, a backlight unit which generates light, a diffuser which is interposed between the first polarizer and the backlight unit and has an anisotropic region having a transmission axis substantially parallel to the first direction and a diffusion axis which is substantially perpendicular to the first direction and substantially parallel to a second direction, and a photographing unit which is interposed between the anisotropic region and the backlight unit and photographs the image of a subject through the display panel.

Document JP 2014 138290 A discloses an imaging device comprising: an imaging unit that images a subject to acquire image information; a focusing position control unit that controls a focus position of the imaging unit; a distance measuring unit that acquires distance information from its own device to the subject; an information storage unit that holds blur characteristics information of an optical system of the imaging unit; and a blur removal processing unit that removes a blur of the image information. The blur removal processing unit removes the blur of the image information on the basis of the blur characteristics information corresponding to focusing information and the distance information.

Document US 2012/050601 A1 discloses a method of controlling a digital photographing apparatus, and a digital photographing apparatus, in which a child's face is registered in the digital photographing apparatus, and the child's interest is continuously attracted by using a preferred image and sound of the child. Thus, an inattentive child's interest may be attracted to a camera and thus the child may be photographed while the child is focusing on images displayed on the camera.

JP 2006 060535 A discloses a portable telephone system provided with: the imaging means; a main displaying means having a display screen capable of displaying an image picked up by the imaging means on a side opposite from a lens mounted face of the imaging means; a sub displaying means having a display screen displaying another image independently of the main displaying means on the side of the lens mounted face; communicating means; and a key inputting means for inputting communication related information. The portable telephone system is provided with: a magnifying glass mode setting means for setting an operation mode to a magnifying glass mode for displaying a photographed image picked up by the imaging means on the display screen of the main displaying means by expanding the photographed image to an unmagnified image or a greater one; and a control means for controlling the display screen of the sub displaying means so as to be full high luminance display when the magnifying glass mode setting means sets the magnifying glass mode.

### [Citation List]

### [Patent Literature]

[PTL1]
U.S. Published Application No. 2018/0069060

### [Summary]

### [Technical Problem]

However, part of the light having passed through the display unit enters the camera while involving reflection or diffraction. Accordingly, there arises a problem of image quality deterioration of the captured image due to an effect of a flare resulting from reflection or an effect of diffraction.

An aspect of the present disclosure provides an electronic apparatus capable of preventing image quality deterioration of an image captured by a camera while reducing a width of a bezel.

### [Solution to Problem]

The problem is solved by the teachings of the independent claim. Further embodiments are defined in the dependent claims. The invention is defined by the appended claims. References to embodiments which do not fall under the scope of the claims are to be understood as examples useful for understanding the invention.

According to an aspect of the present disclosure, an electronic apparatus includes a display unit, a plurality of imaging optical systems, and an image acquisition unit. The display unit has a displayable region that includes display optical systems disposed in an array in a first direction and a second direction intersecting the first direction. The plurality of imaging optical systems is disposed on a side opposite to a display surface of the display unit and overlapped with the displayable region in a third direction intersecting the first direction and the second direction, and includes at least a first imaging optical system and a second imaging optical system having coordinates different from coordinates of the first imaging optical system in at least one of the first direction and the second direction. The image acquisition unit acquires image data on the basis of information acquired by the first imaging optical system and the second imaging optical system. In this manner, a position where a flare is generated in a captured image can be varied by shifting at least positions of the two imaging optical systems. For example, the first imaging optical system and the second imaging optical system may be two optical systems freely selected from the plurality of imaging optical systems. In other words, configurations described below may correspond to characteristics of at least two of the plurality of imaging optical systems. Moreover, one characteristic may be based on a combination of a first optical system and a second optical system, and another characteristic may be based on another combination of a first optical system and a second optical system. In this manner, following characteristics may be associated with at least two of the plurality of imaging optical systems.

In the electronic apparatus, light may propagate from the display surface of the display unit to the first imaging optical system and the second imaging optical system via optical systems having different optical characteristics. Moreover, all of the plurality of imaging optical systems may have different optical characteristics, or some of the plurality of imaging optical systems may have the same optical characteristic. In this manner, at least two of the imaging optical systems may have different optical characteristics in terms of an optical path of light propagated from the display surface. The characteristic of the generated flare may be varied by providing different optical characteristics.

The electronic apparatus has openings through which light having entered the display unit from the display surface propagates. Light having entered from the display surface propagates to the imaging optical systems via the openings. For example, the above optical characteristics may be produced by the openings.

A layout of the opening through which light propagates to the first imaging optical system is different from a layout of the opening through which light propagates to the second imaging optical system. Different optical characteristics may be produced by these layouts.

The opening through which light propagates to the first imaging optical system and the opening through which light propagates to the second imaging optical system may form diffraction images in different directions. For example, the opening through which light propagates to the first imaging optical system may be configured such that the size of the opening in the first direction is larger than the size of the opening in the second direction, while the opening through which light propagates to the second imaging optical system may be configured such that the size of the opening in the second direction is larger than the size of the opening in the first direction. In this manner, with the openings causing formation of diffraction images in different directions, the directions of flare generation of the two imaging optical systems can be varied.

The electronic apparatus may further include a third imaging optical system that has identical disparity between the first imaging optical system and the third imaging optical system to disparity between the first imaging optical system and the second imaging optical system. The image acquisition unit may acquire the image data on the basis of information obtained from information acquired by the second imaging optical system and the third imaging optical system, and of information acquired by the first imaging optical system. In other words, for a combination of certain two imaging optical systems, the electronic apparatus may further include an imaging optical system which has equivalent disparity in the opposite direction with respect to either one of the two imaging optical systems as a center.

The first imaging optical system may be provided near a center of the display surface in the first direction or the second direction. The second imaging optical system and the third imaging optical system may be provided near a boundary of the display surface in such a manner that the first imaging optical system is sandwiched between the second imaging optical system and the third imaging optical system in the first direction or the second direction. An area that is included in the first imaging optical system and faces the display surface in the third direction may be smaller than areas that are included in the second imaging optical system and the third imaging optical system and face the display surface in the third direction. In other words, the second and third imaging optical systems may be provided at one and the other ends of the display surface of the electronic apparatus 1, respectively. The first imaging optical system which is less conspicuous than the second and third imaging optical systems may be provided near the center.

Arrangement of the first imaging optical system and arrangement of the second imaging optical system may have different coordinates in both the first direction and the second direction. In this manner, the two imaging optical systems may have different coordinates in the first direction only, in the second direction only, or in both the first direction and the second direction. Specifically, the two imaging optical systems may be disposed side by side on the display surface in a horizontal direction, in a vertical direction, or in any direction.

In the case of merging of data acquired from the first imaging optical system and data acquired from the second imaging optical system, the image acquisition unit may acquire an imaging result on the basis of data having low intensity at a position in the image data corresponding to a merging result. A flare in acquisition data often has higher luminance and light intensity than those of an object desired to be imaged. Accordingly, in the case of acquisition of image data, the image acquisition unit may acquire an image on the basis of a signal having lower intensity in signals acquired from the two imaging optical systems.

The first imaging optical system and the second imaging optical system may each have a direction in which to perform reflection with priority. In a case where a difference of a predetermined value or larger is produced between outputs in the respective directions, the image acquisition unit may acquire an imaging result by using either one of results. For example, in a case where a flare is generated in the first direction by the first imaging optical system and a flare is generated in the second direction by the second imaging optical system, the image acquisition unit may acquire image data on the basis of output from the imaging optical system generating a smaller flare.

Light shielding may be provided between the first imaging optical system and the second imaging optical system. In this manner, light shielding may be provided between the first imaging optical system and the second imaging optical system to reduce effects mutually applied on the optical systems.

The image acquisition unit may merge information acquired by the first imaging optical system and information acquired by the second imaging optical system by using a trained model. In this manner, data output from the plurality of imaging optical systems may be merged using a model created by machine learning, for example.

The trained model may be trained on the basis of data collected from a plurality of electronic apparatuses. For example, the model may be created on the basis of the electronic apparatuses 1 manufactured with an identical model number. Moreover, within the model number, the model may be changed and trained on the basis of an imaging mode or the like.

The image acquisition unit may perform correction in a case where disparity between a plurality of images acquired by a plurality of the imaging optical systems exceeds a predetermined amount. For example, image data may be acquired by detecting a region where a flare is generated on the basis of disparity and performing image processing on the region.

At least one of the imaging optical systems may include a micro-lens array. In this manner, one imaging system may include not a single lens but a lens system.

A plurality of the imaging optical systems may be provided in a region where the micro-lens array is provided. In this manner, a plurality of imaging optical systems may be formed using one micro-lens array.

The first imaging optical system and the second imaging optical system may acquire information by using an identical imaging element. In this manner, a plurality of imaging optical systems may be formed for one imaging element, such as one-chip imaging element. As a configuration combined with the above, the micro-lens array may be provided for one chip to achieve a configuration in which a plurality of imaging optical systems is provided for each region.

The image acquisition unit may be disposed on a chip same as a chip of the imaging element. For example, the imaging element and a logic circuit may be provided on one chip, DA conversion may be performed on data acquired by the imaging element, and the converted data may be processed by the logic circuit. The chip may be constituted as not one chip but a plurality of laminated chips.

The display unit may include a plurality of the display optical systems having different optical characteristics. For example, the display optical systems may include a mixture of an OLED, a MicroLED, a liquid crystal, and the like. In this case, the characteristic of the flare generated on the basis of a result of reflection, refraction, or diffraction in the display unit can be varied by the imaging optical systems.

At least one of the plurality of imaging optical systems may operate in a case where signal correction is required in the image acquisition unit. For example, whether to perform correction using the imaging optical systems may be switched on the basis of an ambient environment, such as an imaging element provided for performing correction in the case of detection of an intense light source by the electronic apparatus.

The first imaging optical system and the second imaging optical system may be integrated into one body. For example, light reception elements and optical paths to the light reception elements of the two imaging optical systems may be disposed adjacent to each other.

The first imaging optical system and the second imaging optical system may be provided near a boundary of the display surface. The boundary refers to an end portion of the display surface, for example. The plurality of imaging optical systems may be provided at this end portion.

The first imaging optical system and the second imaging optical system may be disposed away from each other by a distance ranging from 50 to 80 mm. The image acquisition unit may generate disparity image data of information acquired by the first imaging optical system and the second imaging optical system. In this manner, the two imaging optical systems may be disposed away from each other by a distance equivalent to a distance between both eyes of a human.

The display unit may be provided on both surfaces of a device. In this case, a plurality of imaging optical systems may be provided for each of plural display units. Alternatively, a plurality of imaging optical systems may be provided on one of the display units, and no imaging optical system may be provided on the other display unit. Alternatively, one imaging optical system may be provided on one of the display units, and a plurality of imaging optical systems may be provided on the other display unit.

An electronic apparatus may include a fourth imaging optical system different from the first imaging optical system and the second imaging optical system. In this case, the electronic apparatus may have any one of the above characteristics with respect to the fourth imaging optical system and the first imaging optical system or the second imaging optical system. As initially described, the first imaging optical system and the second imaging optical system are any two imaging optical systems selected from the plurality of imaging optical systems, and do not represent specific imaging optical systems.

### [Brief Description of Drawings]

[FIG. 1]

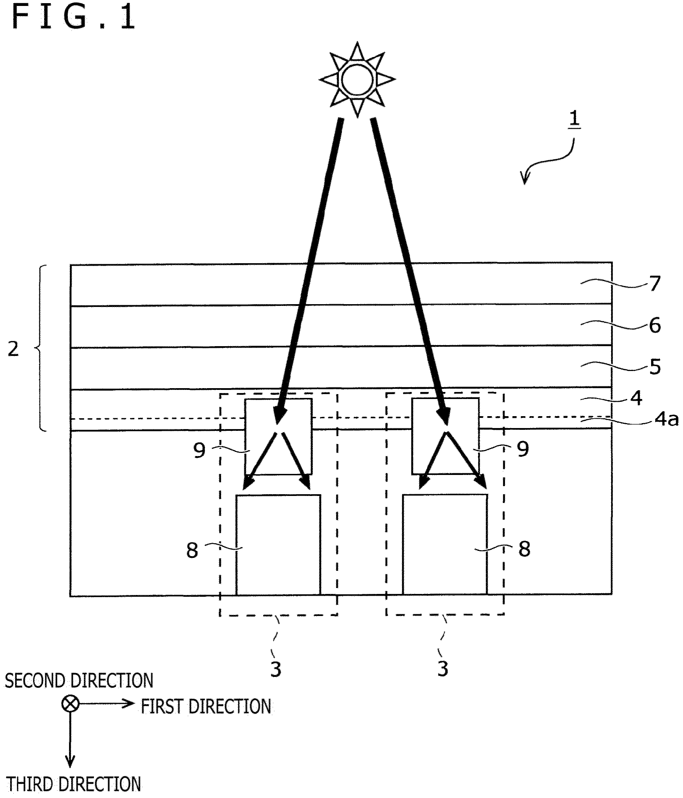

   FIG. 1 is a schematic cross-sectional diagram of an electronic apparatus according to one embodiment.
[FIG. 2]

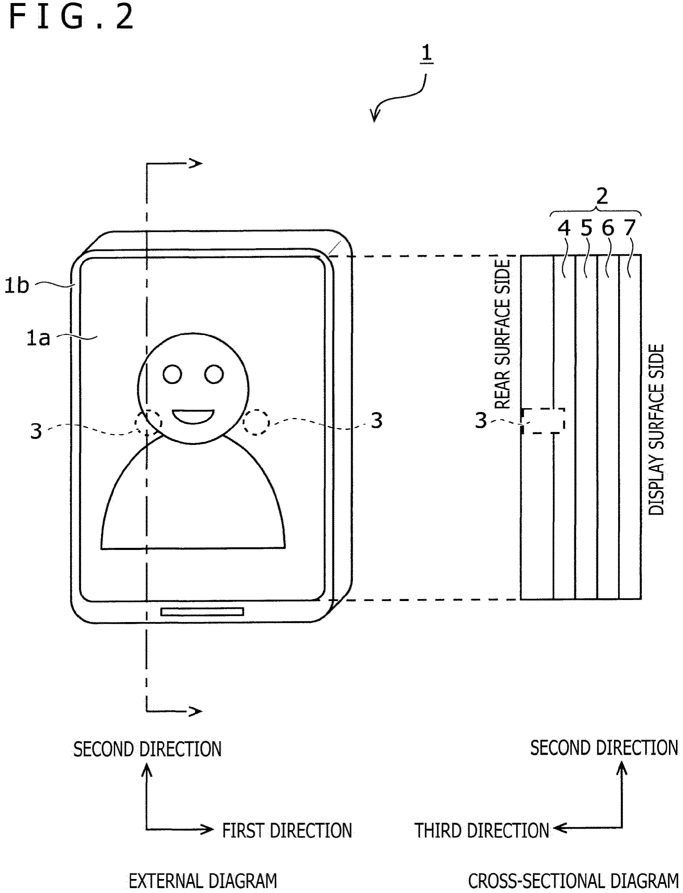

   FIG. 2 is a schematic external diagram of the electronic apparatus according to one embodiment.
[FIG. 3A]

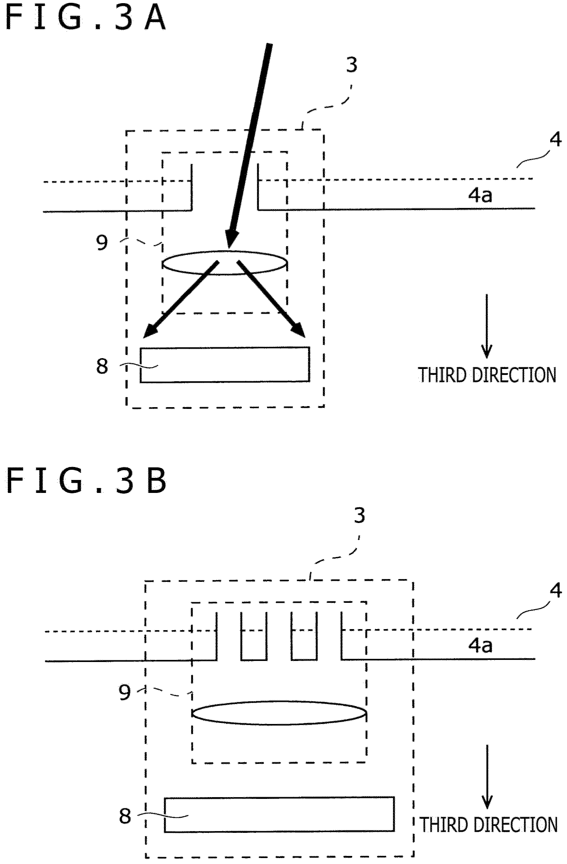

   FIG. 3A is a schematic diagram depicting an example of an imaging optical system according to one embodiment.
[FIG. 3B]
   FIG. 3B is a schematic diagram depicting an example of the imaging optical system according to one embodiment.
[FIG. 4]

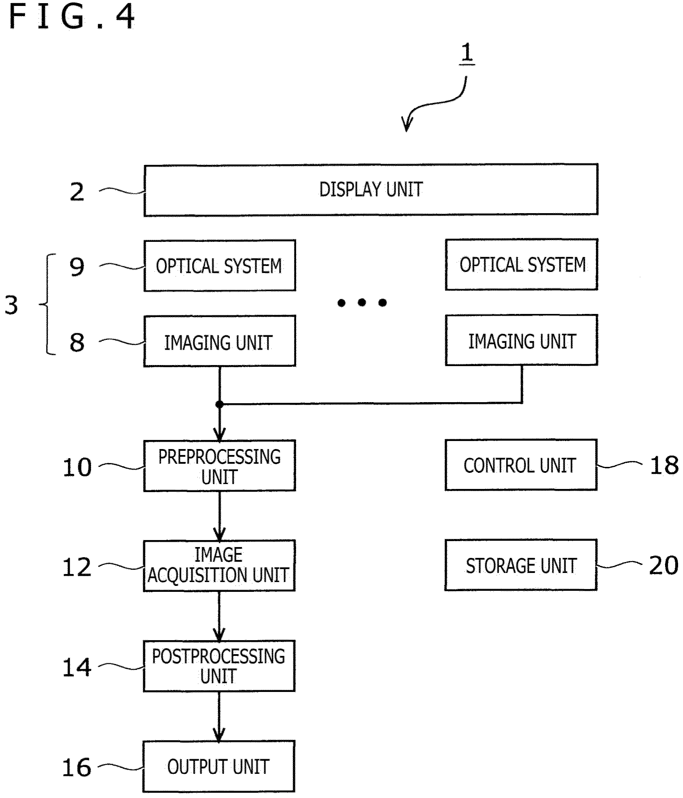

   FIG. 4 is a block diagram associated with an imaging operation of the electronic apparatus according to one embodiment.
[FIG. 5]

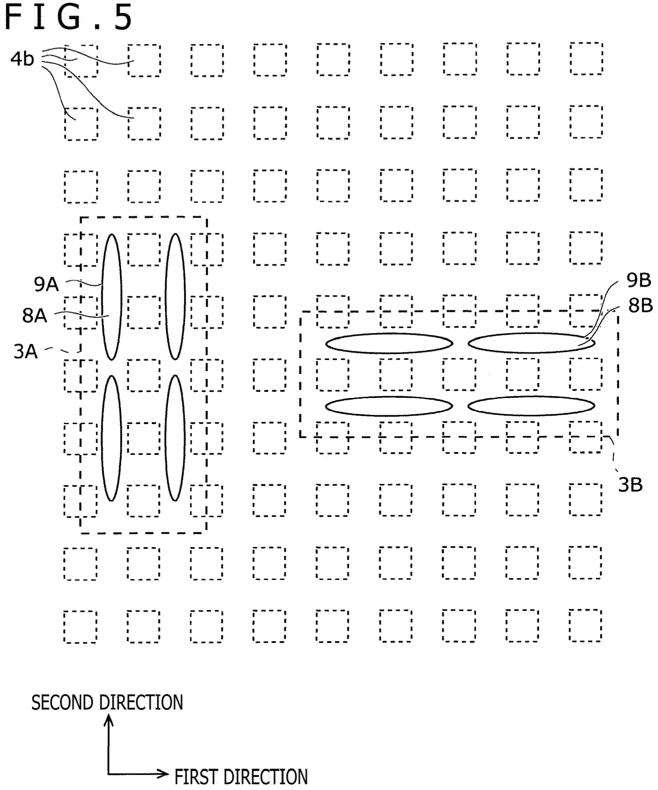

   FIG. 5 is a diagram depicting imaging optical systems according to one embodiment as viewed from a display surface side.
[FIG. 6A]

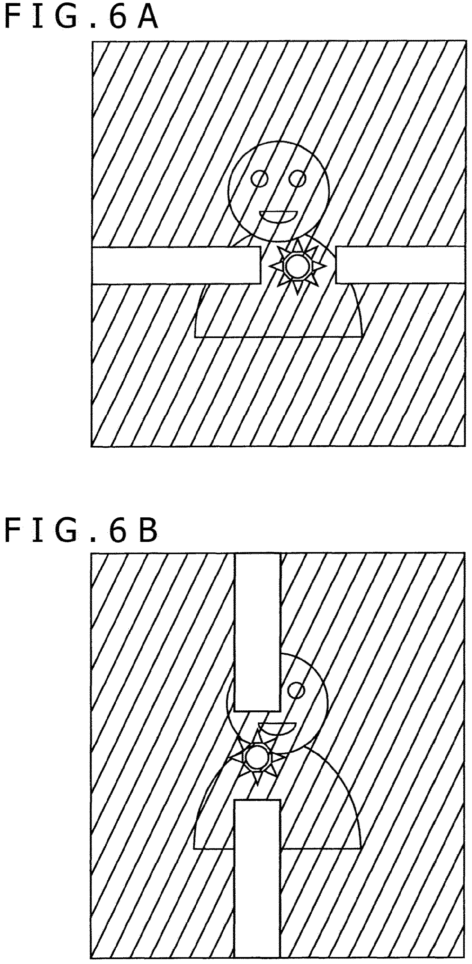

   FIG. 6A is a diagram depicting an example of an image captured by the imaging optical systems in FIG. 5.
[FIG. 6B]
   FIG. 6B is a diagram depicting an example of an image captured by the imaging optical systems in FIG. 5.
[FIG. 7]

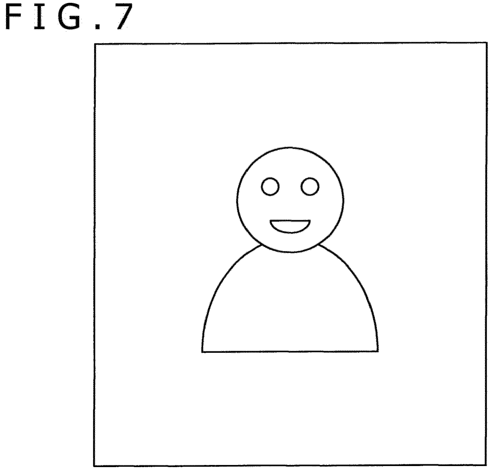

   FIG. 7 is a diagram depicting an example of an image captured by an image acquisition unit according to one embodiment.
[FIG. 8]

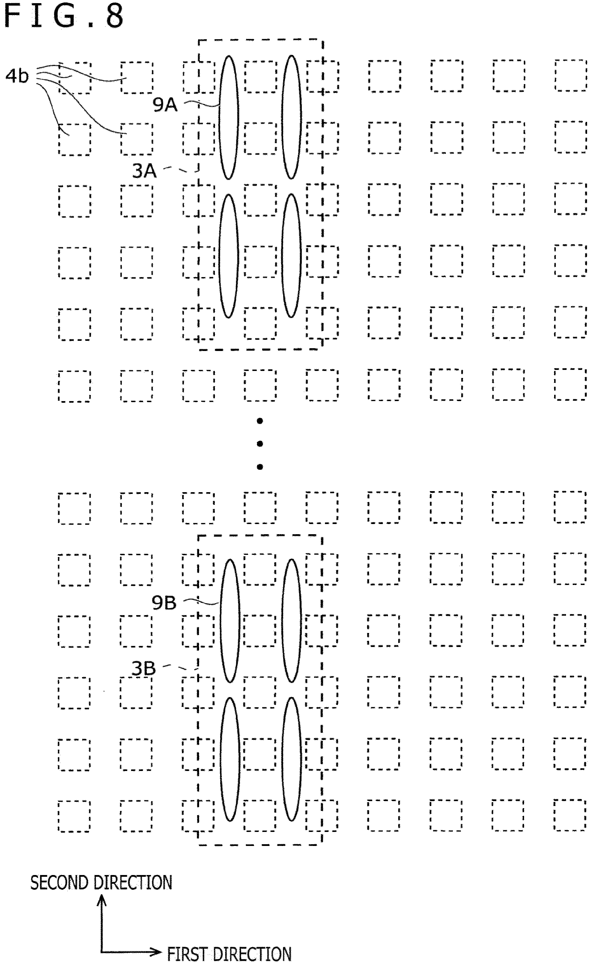

   FIG. 8 is a diagram depicting the imaging optical systems according to one embodiment as viewed from the display surface side.
[FIG. 9]

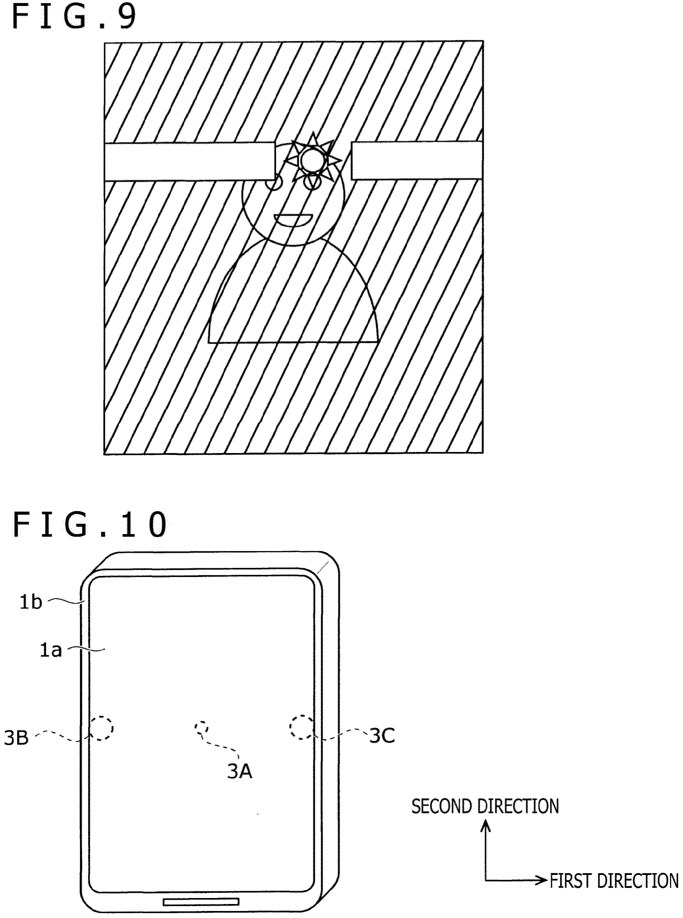

   FIG. 9 is a diagram depicting an example of an image captured by the imaging optical systems in FIG. 8.
[FIG. 10]
   FIG. 10 is a schematic external diagram of the electronic apparatus according to one embodiment.
[FIG. 11]

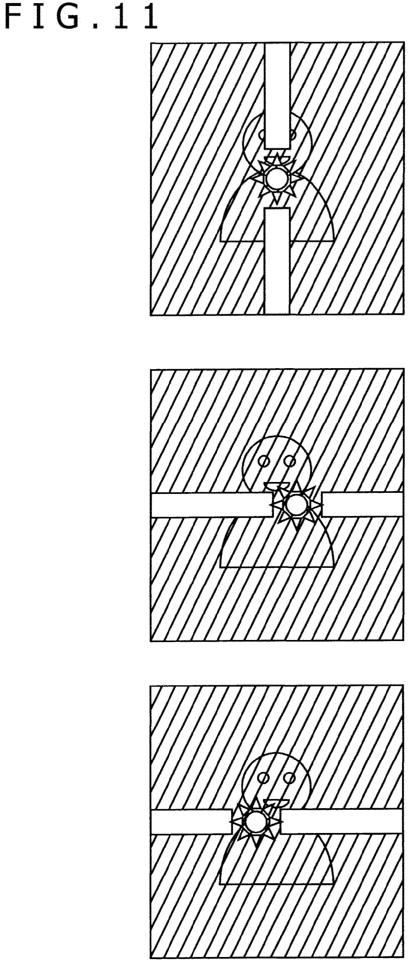

   FIG. 11 is a diagram depicting examples of images captured by the imaging optical systems in FIG. 10.
[FIG. 12]

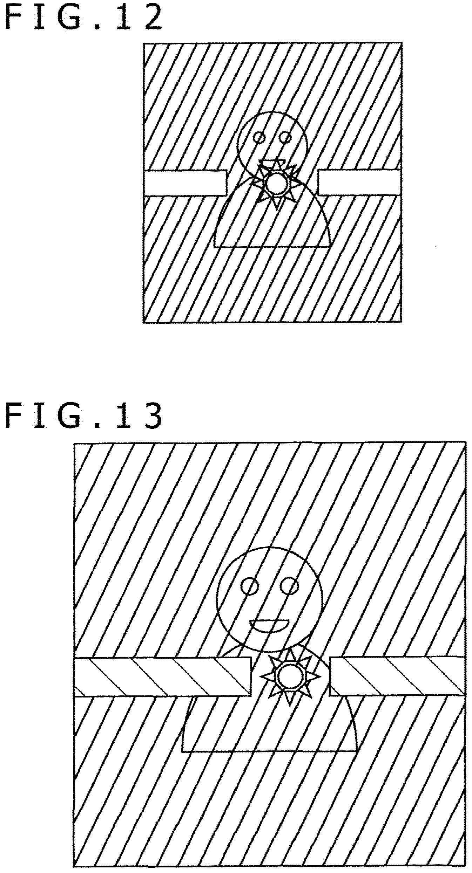

   FIG. 12 is a diagram depicting an example of merging of images captured by the imaging optical systems disposed at both ends in FIG. 11.
[FIG. 13]
   FIG. 13 is a diagram depicting an example of an image captured by the imaging optical systems according to one embodiment.
[FIG. 14]

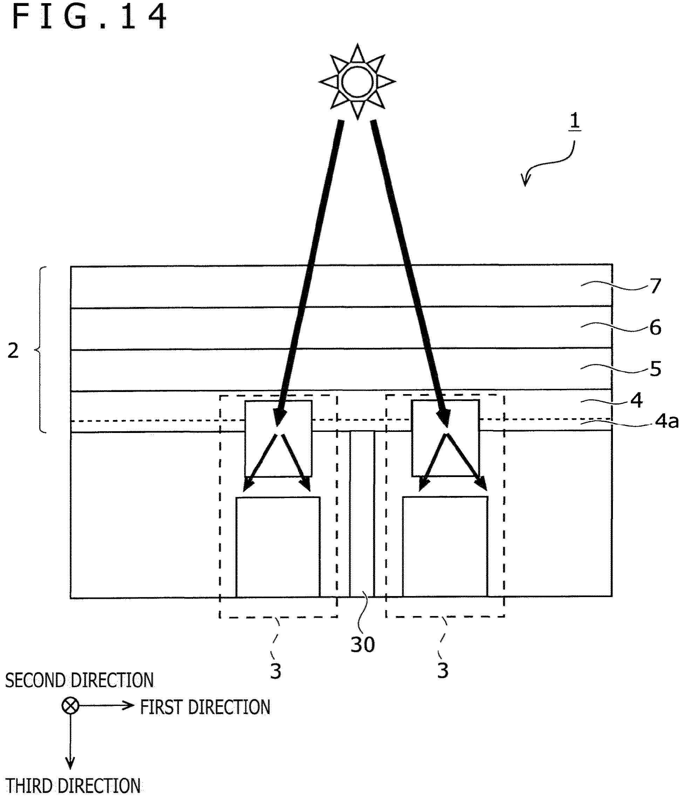

   FIG. 14 is a schematic cross-sectional diagram of the electronic apparatus according to one embodiment.
[FIG. 15]

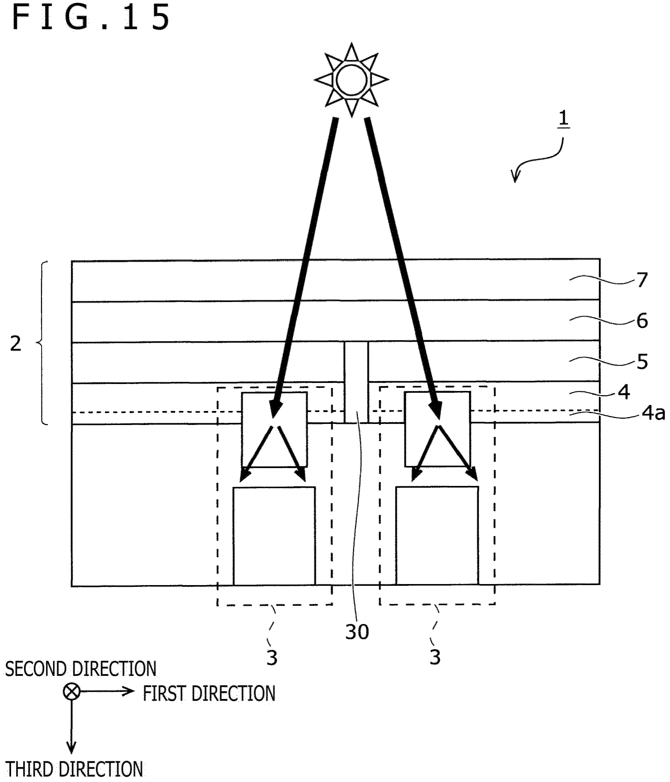

   FIG. 15 is a schematic cross-sectional diagram of the electronic apparatus according to one embodiment.
[FIG. 16]

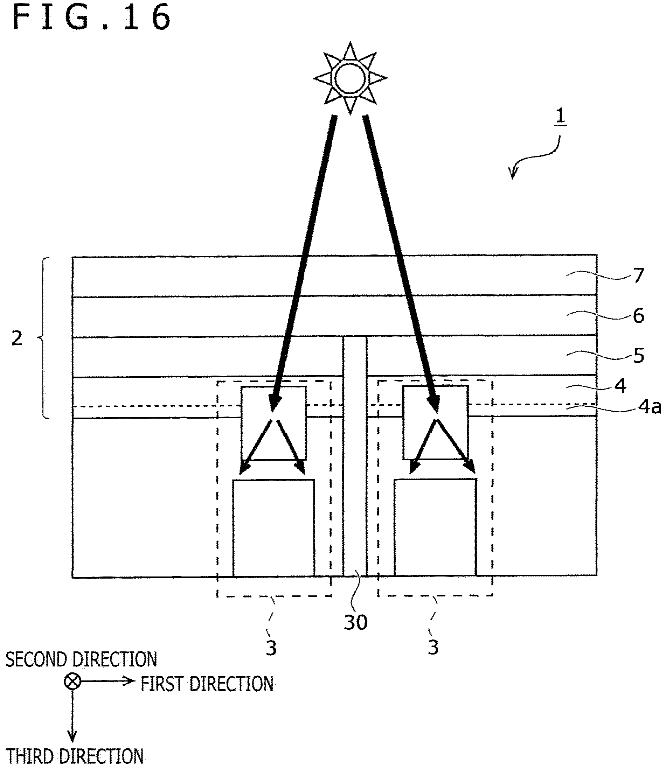

   FIG. 16 is a schematic cross-sectional diagram of the electronic apparatus according to one embodiment.
[FIG. 17]
   FIG. 17 is a schematic diagram depicting an example of the imaging optical system according to one embodiment.[FIG. 18]
FIG. 18 is a schematic diagram depicting an example of the imaging optical systems according to one embodiment.
[FIG. 19]

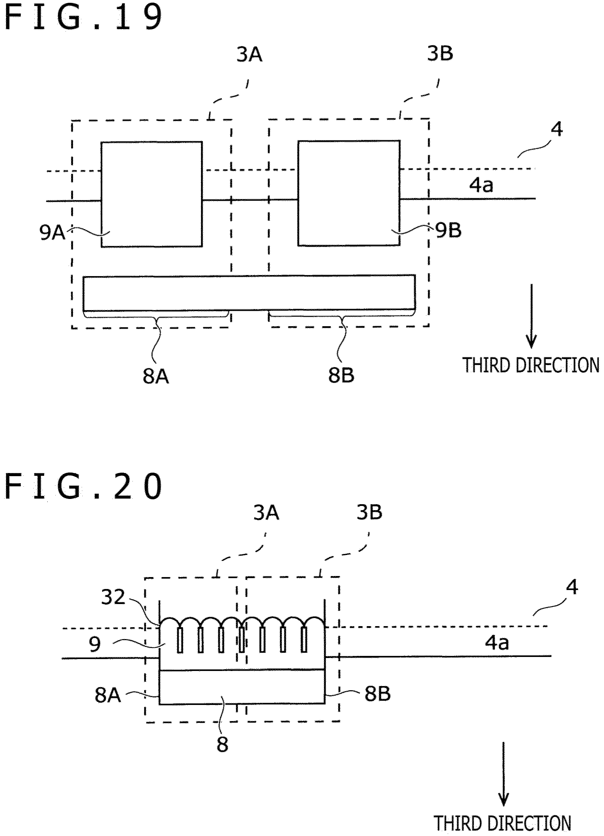

   FIG. 19 is a schematic diagram depicting an example of the imaging optical systems according to one embodiment.
[FIG. 20]
   FIG. 20 is a schematic diagram depicting an example of the imaging optical systems according to one embodiment.
[FIG. 21]

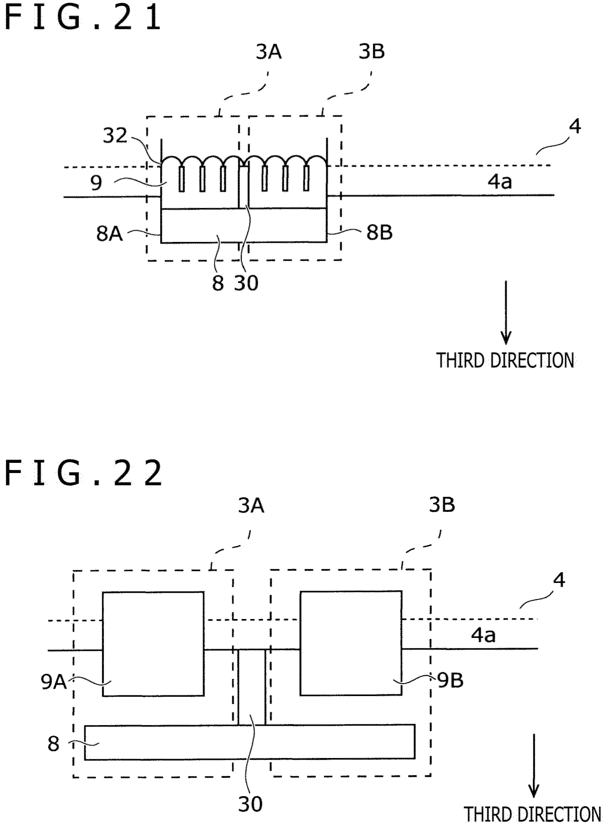

   FIG. 21 is a schematic diagram depicting an example of the imaging optical systems according to one embodiment.
[FIG. 22]
   FIG. 22 is a schematic diagram depicting an example of the imaging optical systems according to one embodiment.
[FIG. 23A]

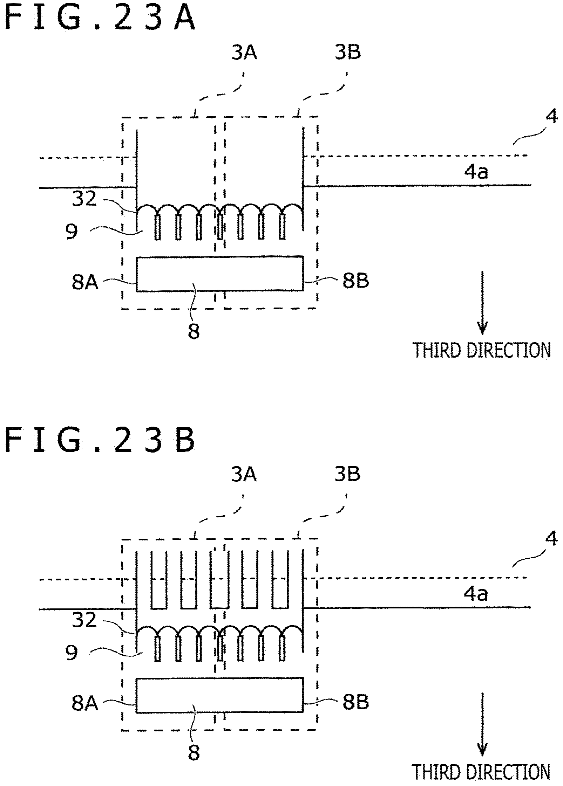

   FIG. 23A is a schematic diagram depicting an example of the imaging optical systems according to one embodiment.
[FIG. 23B]
   FIG. 23B is a schematic diagram depicting an example of the imaging optical systems according to one embodiment.
[FIG. 24]

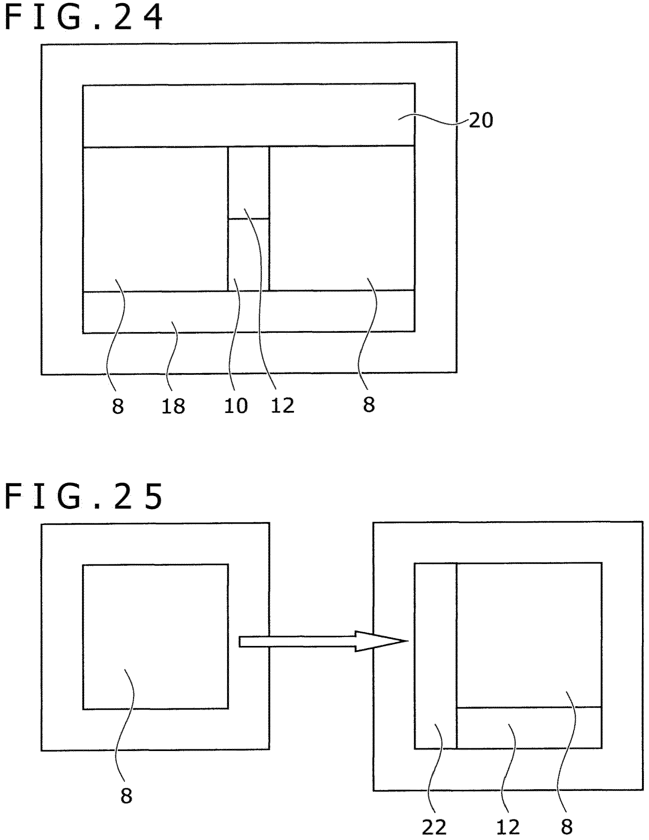

   FIG. 24 is a schematic diagram depicting an example of implementation of imaging units according to one embodiment.
[FIG. 25]
   FIG. 25 is a schematic diagram depicting an example of implementation of the imaging units according to one embodiment.
[FIG. 26]

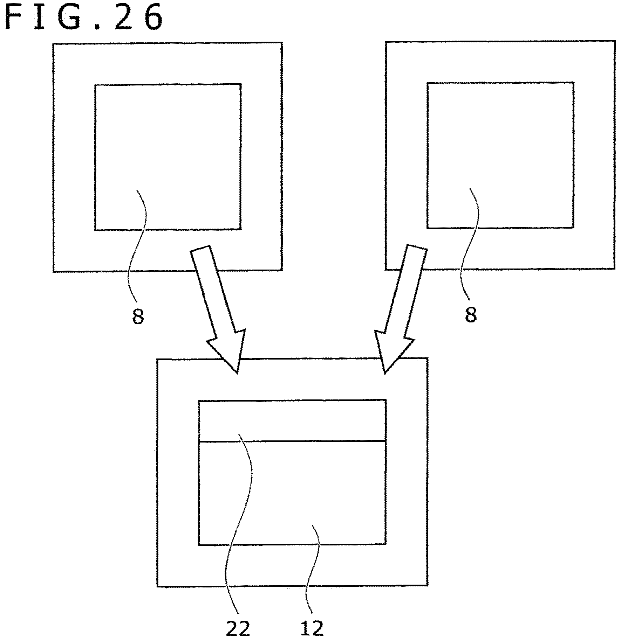

   FIG. 26 is a schematic diagram depicting an example of implementation of the imaging units according to one embodiment.
[FIG. 27]

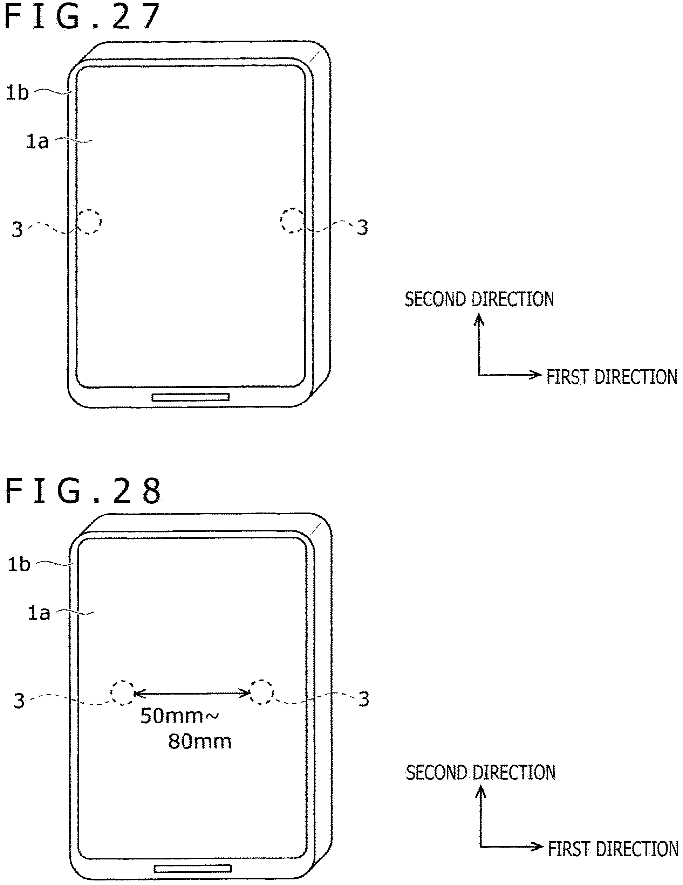

   FIG. 27 is a schematic diagram depicting an arrangement example of the imaging optical systems according to one embodiment.
[FIG. 28]
   FIG. 28 is a schematic diagram depicting an arrangement example of the imaging optical systems according to one embodiment.
[FIG. 29]

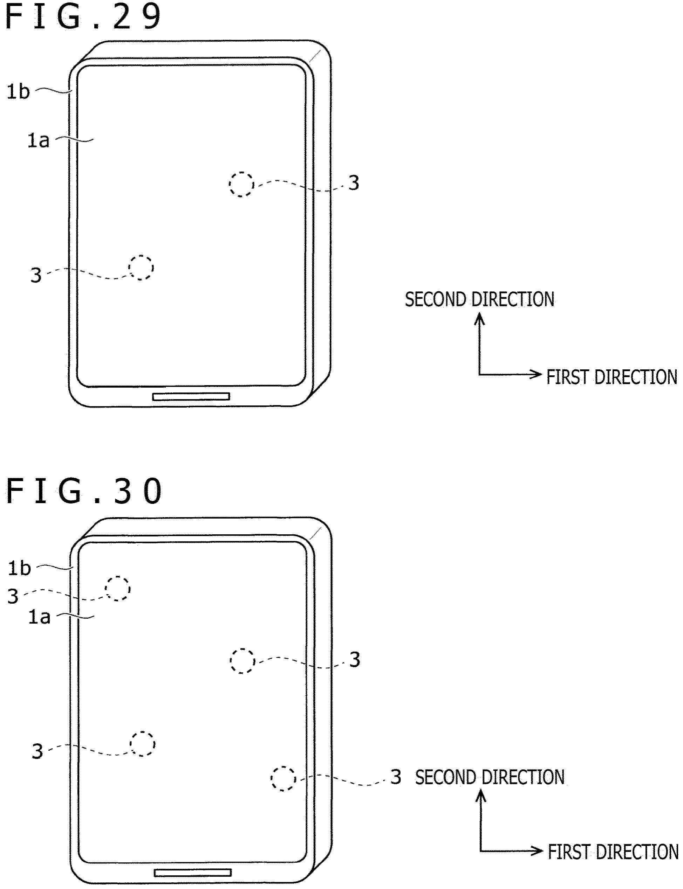

   FIG. 29 is a schematic diagram depicting an arrangement example of the imaging optical systems according to one embodiment.
[FIG. 30]
   FIG. 30 is a schematic diagram depicting an arrangement example of the imaging optical systems according to one embodiment.
[FIG. 31A]

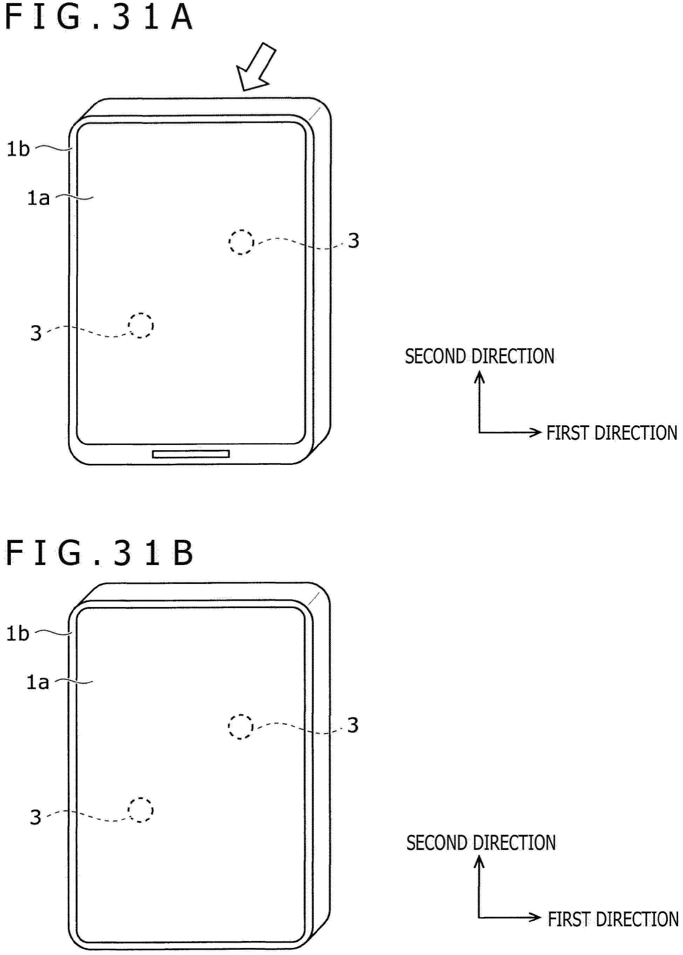

   FIG. 31A is a schematic diagram depicting an arrangement example of the imaging optical systems according to one embodiment.
[FIG. 31B]
   FIG. 31B is a schematic diagram depicting an arrangement example of the imaging optical systems according to one embodiment.
[FIG. 32]

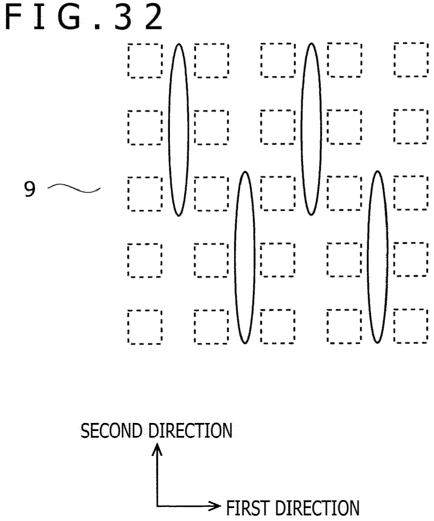

   FIG. 32 is a diagram depicting a layout example of openings according to one embodiment.
[FIG. 33]

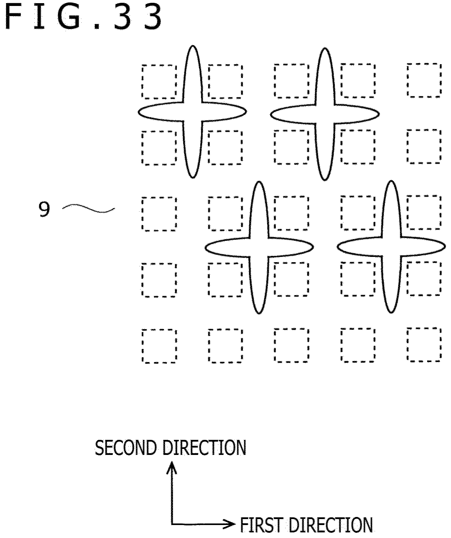

   FIG. 33 is a diagram depicting a layout example of openings according to one embodiment.
[FIG. 34]

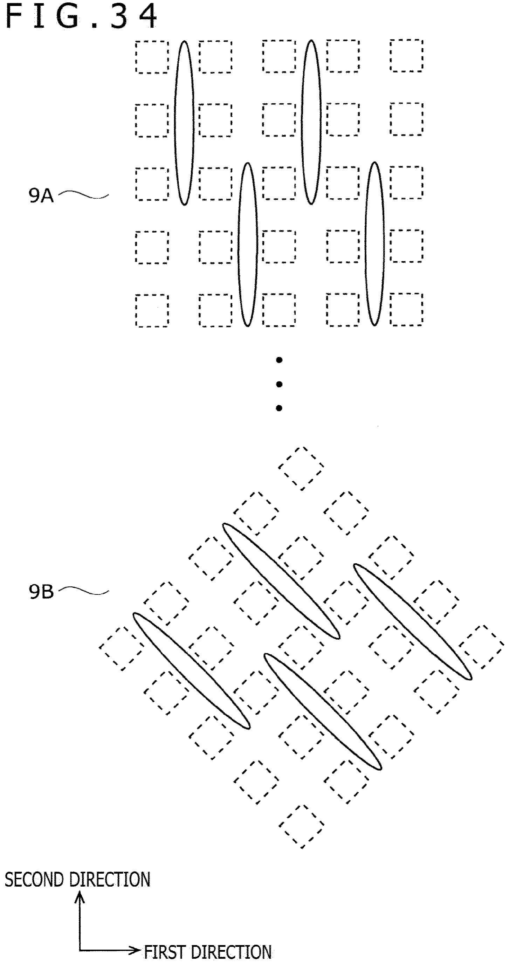

   FIG. 34 is a diagram depicting a layout example of openings according to one embodiment.
[FIG. 35]

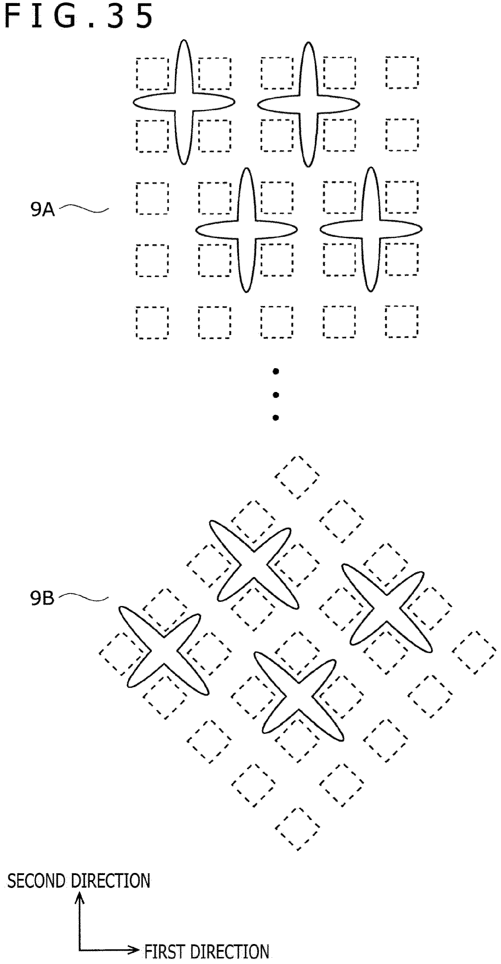

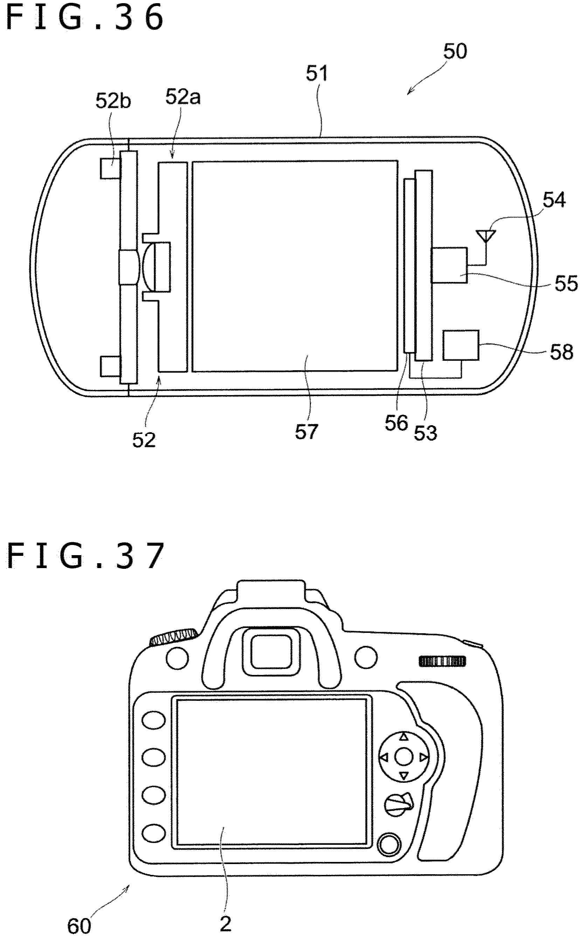

   FIG. 35 is a diagram depicting a layout example of openings according to one embodiment.[FIG. 36]
FIG. 36 is a plan diagram in a case where the electronic apparatus of one embodiment is applied to a capsule endoscope.
[FIG. 37]
   FIG. 37 is a rear diagram in a case where the electronic apparatus of one embodiment is applied to a digital single lens reflex camera.
[FIG. 38A]

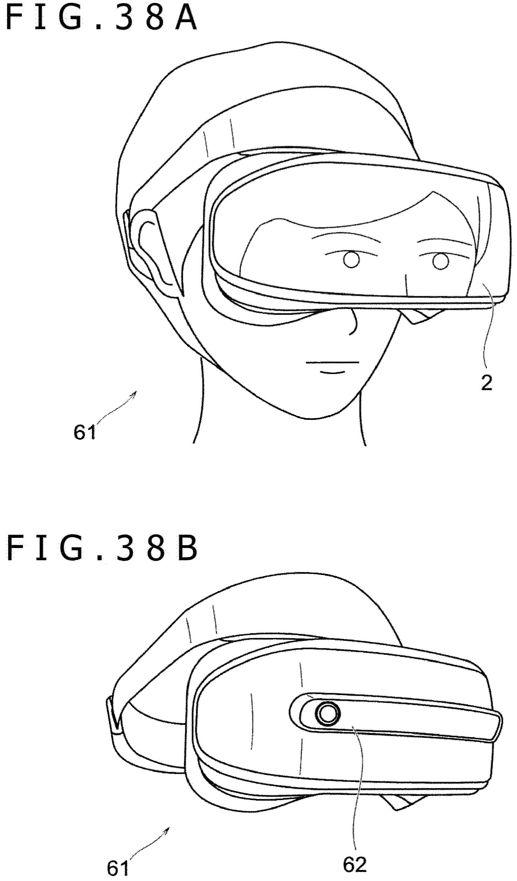

   FIG. 38A is a diagram depicting an example where the electronic apparatus of one embodiment is applied to an HMD.
[FIG. 38B]
   FIG. 38B is a diagram depicting an HMD currently available.

### [Description of Embodiments]

Embodiments of an electronic apparatus will be hereinafter described with reference to the drawings. A main constituent part of the electronic apparatus will be chiefly explained hereinbelow. However, the electronic apparatus may have constituent parts and functions not depicted nor described. The following description does not exclude the constituent parts and functions not depicted nor described. Moreover, some sizes, shapes, aspect ratios, and the like are changed for convenience of explanation. However, these are actually sizes, shapes, aspect ratios and the like appropriate for implementation. Note that acquired signals in the following description are expressed as image information or imaging information. However, the image information and imaging information are defined as concepts in a wide sense, and include a still image, a moving image, an image in one frame of a video, or the like as well.

(First embodiment) FIG. 1 is a schematic cross-sectional diagram of an electronic apparatus 1 according to a first embodiment. The electronic apparatus 1 in FIG. 1 is any type of electronic apparatus having both a display function and an imaging function, such as a smartphone, a cellular phone, a tablet, and a PC. As depicted in a lower left part in the figure, it is assumed that a first direction is a rightward direction in the figure, that a second direction is a direction perpendicular to a figure plane, and that a third direction is a downward direction in the figure. In other words, the second direction is a direction intersecting the first direction, and the third direction is a direction intersecting the first direction and the second direction. Note that "intersecting" may include intersecting at an angle of 90 degrees, but is not required to have 90 degrees in a rigorous sense. Moreover, as obvious from the figure, the first direction and the second direction are discriminated only for convenience. Accordingly, the above description similarly applies even if these directions are switched to each other.

The electronic apparatus 1 in FIG. 1 includes imaging optical systems (e.g., camera modules) disposed on the side opposite to a display surface of a display unit 2. In this manner, the electronic apparatus 1 has imaging optical systems 3 provided on a rear side (opposite side) of the display surface of the display unit 2. Accordingly, the imaging optical systems 3 each perform imaging via the display unit 2.

As depicted in FIG. 1, the display unit 2 is a structure body produced by sequentially laminating a display panel 4, a circularly polarizing plate 5, a touch panel 6, and a cover glass 7. This lamination in FIG. 1 is presented only by way of example. Adhesive layers or bonding layers may be provided as necessary between the display panel 4, the circularly polarizing plate 5, the touch panel 6, and the cover glass 7. Moreover, the order of the circularly polarizing plate 5 and the touch panel 6 may be switched as necessary according to the design thereof.

The imaging optical systems 3 are provided on the side opposite to the display surface of the display unit 2. For example, each of the imaging optical systems 3 includes a photoelectric element (light receiving element) which receives light and photoelectrically converts the light into an analog signal, and an optical system which propagates light applied to the display surface toward the photoelectric element. For example, the optical system may be an opening formed in the display panel 4. A plurality of the imaging optical systems 3 thus configured is provided for one display unit 2 of the electronic apparatus 1. For example, two imaging optical systems 3 are provided as depicted in the figure. The light applied to the display surface is diffracted at the openings and propagated toward the light receiving elements as indicated by arrows in the figure. In addition, the optical systems to be provided are not limited to the openings but may be optical systems each having some optical characteristics, such as an optical characteristic capable of adjusting an optical path length or an optical characteristic capable of changing a polarized state. For example, each of the imaging optical systems 3 includes an imaging unit 8 and an optical system 9 which performs processes such as collection and diffusion of light having entered the display surface toward the imaging unit 8.

For example, the plural imaging optical systems 3 are disposed at positions of different coordinates in the first direction as depicted in the figure. However, other arrangement may be adopted. For example, the plural imaging optical systems 3 may have different coordinates in the second direction or may have different coordinates in both of the first and second directions.

While not depicted in detail, the display panel 4 may have an OLED (Organic Light Emitting Device), a liquid crystal including TFTs or the like, or MicroLEDs as an optical system for display (display optical system), for example. The display optical system may have light emitting elements based on other display principles. For example, the light emitting elements constituting the display optical system may have a stripe arrangement or a mosaic arrangement. Alternatively, the light emitting elements may be disposed in an array in the first and second directions, or pixels may be thinned out in an oblique direction or partially. Moreover, the light emitting elements of the display optical system may each include a laminated type filter to change a display color. In the case where an OLED or the like is provided, the display panel 4 may include a plurality of layers such as an anode layer and a cathode layer. Moreover, each of these layers may include a material having high transmittance.

The display panel 4 has a component having low transmittance, such as a color filter layer, in some cases. Moreover, in the case where the display panel 4 has an OLED, the display panel 4 may include a substrate 4a and an OLED portion, for example. The substrate 4a may include polyimide or the like, for example. In the case where the substrate 4a includes a material having low light transmittance, such as polyimide, the substrate 4a may have openings formed in alignment with the positions of the imaging optical systems 3. By introducing object light having passed through the openings into the imaging optical systems 3, it is possible to improve image quality of images captured by the imaging optical systems 3. Alternatively, light propagation paths each including a substance having high transmittance may be formed instead of the openings. In this case, the light having entered from the display surface of the display unit 2 is similarly received by the imaging optical systems 3 and converted into signals.

For example, the circularly polarizing plate 5 is provided to reduce glare or increase visibility of a display screen 1a even under a bright environment. A touch sensor is incorporated in the touch panel 6. There are various types of touch sensors, such as a capacitance type and a resistive film type. Any type of these may be adopted. Moreover, the touch panel 6 and the display panel 4 may be integrated into one body. The cover glass 7 is provided to protect the display panel 4 and others. As described above, a bonding layer or an adhesive layer, such as an OCA (Optical Clear Adhesive), may be provided at an appropriate position. Moreover, the order of the circularly polarizing plate 5 and the touch panel 6 in the third direction may be switched according to design.

FIG. 2 illustrates schematic external and cross-sectional diagrams of the electronic apparatus 1 depicted in FIG. 1. The cross-sectional diagram illustrates a cross section of a display portion taken along a one-dot chain line in the figure and including the display unit 2. Circuits and the like other than a housing and the display portion of the electronic apparatus 1 are not depicted.

In the external diagram, the display screen 1a spreads up to a size close to an outside diameter size of the electronic apparatus 1. A width of a bezel 1b provided around the display screen 1a has a length of several millimeters or smaller. Generally, a front camera is often mounted on the bezel 1b. According to the present embodiment, for example, front cameras corresponding to the plurality of imaging optical systems 3 may be located substantially at the center of the display screen 1a in the second direction as indicated by dotted lines in the external diagram. As described above, the front cameras as the imaging optical systems 3 are disposed on the side opposite to the display surface of the display unit 2. Accordingly, the necessity of providing the front cameras on the bezel 1b is eliminated, and therefore, the width of the bezel 1b can be reduced.

Note that the external diagram of FIG. 2 is presented only by way of example. The imaging optical systems 3, i.e., the front cameras may be disposed on the side (rear side) opposite to the display surface of the display unit 2 at any positions on the display screen 1a in the first direction and the second direction. For example, the front cameras may be disposed at circumferential edge portions (end portions, boundary portions) of the display screen 1a. As depicted in the external diagram of FIG. 2, the plural imaging optical systems 3 are so provided as to have different coordinates in the first direction, for example. Even in the case where the imaging optical systems 3 are disposed at any positions, the respective imaging optical systems 3 are only required to be disposed in such positions as to have different coordinates at least in one of the first direction and the second direction. Moreover, while two imaging optical systems 3 are depicted, the number of imaging optical systems 3 is not limited to two. More imaging optical systems may be provided on the side opposite to the display surface.

For example, as depicted in the cross-sectional diagram, the imaging optical systems 3 are provided on the rear surface side opposite to the display front surface side corresponding to the display surface of the display unit 2. Note that this cross-sectional diagram includes omissions. For example, similarly to above, the adhesive layer and the like are included in the configuration of the cross-sectional diagram of FIG. 2 but are not depicted for simplification of explanation.

FIG. 3A is a diagram depicting an example of one of the imaging optical systems 3. For example, the imaging optical system 3 includes the imaging unit 8 and the optical system 9. The optical system 9 is disposed on a light entrance surface side of the imaging unit 8, i.e., on the side near the display unit 2. Light having passed through the display surface of the display unit 2 is propagated to the imaging unit 8 by the optical system 9.

For example, the imaging unit 8 includes a light receiving element such as a photodiode, and a photoelectric element. Light collected and diffused, for example, and propagated by the optical system 9 is received by an imaging pixel array provided on the imaging unit 8 and output as an analog signal. A color filter having a Bayer array or the like, for example, or a lamination-type color filter may be provided on a light entrance surface side of each of imaging elements of the imaging pixel array. In addition, a filter for acquiring a color image may be provided. Moreover, while not depicted in the figure, other elements, circuits, and the like necessary for light reception and output of analog signals are provided. For example, photoelectric conversion may be achieved by a CMOS (Complementary Metal-Oxide-Semiconductor) element or a CCD (Charge Coupled Device) element. In addition, the above-described filter, and further a polarizer or the like may be provided.

For example, the optical system 9 may include a lens. The optical system 9 has a concept which includes an opening formed in the display panel 4 as described above. For example, the optical system 9 may include an opening formed in the display panel 4 and a lens which is disposed at a position closer to the imaging unit 8 than this opening is in the third direction. For example, this opening may be formed in the substrate 4a having lower transmittance, and the lens may be provided to propagate light having passed through the opening portion toward the imaging unit 8. For example, optical characteristics such as a numerical aperture Na and an F-value (F-Number) of the corresponding imaging optical system 3 are defined by the lens and the opening. Moreover, other optical characteristics may be produced by the optical system 9, such as a characteristic that the respective imaging optical systems 3 have different Abbe numbers. The lens depicted as one lens in the figure is not limited to this example and may be provided as a lens system having a plurality of lenses of multiple types.

Note that the opening and the lens are presented only by way of example. The configuration of the optical system 9 is not necessarily limited to this combination. Moreover, while one lens is provided for one opening in the figure, this configuration is not required to be adopted. For example, as depicted in FIG. 3B, a plurality of openings may be formed for one lens in the optical system 9. For example, light emitting elements of the display panel 4 may be provided in a region containing no opening, and the openings may be formed in spaces between the respective light emitting elements. This arrangement allows the imaging optical systems 3 to be disposed without destroying display.

As described above, the plural imaging optical systems 3 may be so formed as to have different optical characteristics according to the shape of the opening, the performance of the lens, or the like. In a case where three or more imaging optical systems 3 are present, each of the optical systems 9 corresponding to the respective imaging optical systems 3 may have a different optical characteristic. In another example, the imaging optical systems 3 may be divided into a plurality of groups, and have different optical characteristics for each group. For example, the shape or orientation of the opening, the material of the lens, or the like of the optical systems 9 may be varied such that two imaging optical systems 3 have a common optical characteristic and that one imaging optical system 3 has a different optical characteristic. A term "layout" of an opening will be used as an expression including the shape or orientation of the opening.

As indicated by arrows in FIG. 3A, light having entered from the display surface side of the display unit 2 is refracted, for example, by the optical system 9 and is received by the imaging unit 8. Display of the display unit 2 may be so adjusted as to provide easily visible display by appropriately reducing reflection and the like at a portion not including the optical system 9 similarly to an ordinary display. For example, an opening is formed between light emitting pixels of the display panel 4, and a lens is provided on the side of the opening opposite to the display surface in the third direction such that light having entered from the display surface is projected toward the imaging unit 8. Moreover, an opening may be formed between each pair of successive light emitting pixels. In other words, such a configuration which has light emitting elements between openings may be adopted.

An example of an imaging function of the electronic apparatus 1 will be described herein.

FIG. 4 depicts an example of a block diagram presenting a configuration associated with an imaging operation of the electronic apparatus 1 according to the present embodiment. The electronic apparatus 1 includes the display unit 2, the plurality of imaging optical systems 3, a preprocessing unit 10, an image acquisition unit 12, a postprocessing unit 14, an output unit 16, a control unit 18, and a storage unit 20.

Similarly to the figures referred to above, the plurality of imaging optical systems 3 is provided for the one display unit 2 on the side opposite to the display surface of the display unit 2. Each of the imaging optical systems 3 includes the imaging unit 8 and the optical system 9.

The preprocessing unit 10 is a circuit which processes an analog signal output from the imaging unit 8. For example, the preprocessing unit 10 includes an ADC (Analog to Digital Converter) to convert the input analog signal into digital image data.

The image acquisition unit 12 acquires a captured image from the digital image data converted by the preprocessing unit 10. The image acquisition unit 12 acquires an imaging result on the basis of the digital image data acquired from the plurality of imaging optical systems 3. More specifically, for example, the image acquisition unit 12 acquires an imaging result obtained after flares generated in the respective imaging optical systems 3 are reduced using image data obtained by the plurality of imaging optical systems 3, and outputs the imaging result.

The postprocessing unit 14 performs appropriate processing for the imaging result output from the image acquisition unit 12, and outputs the processed imaging result. For example, the appropriate processing may be image processing or signal processing such as pixel defect correction, edge emphasis, noise removal, brightness adjustment, color correction, white balance adjustment, distortion correction, and auto-focusing. Moreover, the foregoing appropriate processing may be processing designated by a user.

The output unit 16 outputs information to the outside of the electronic apparatus 1. For example, the output unit 16 includes an output interface. For example, the output interface may be an interface which outputs a digital signal such as a USB (Universal serial Bus), or a user interface such as a display. Moreover, the output interface included in the output unit 16 may also function as an input interface.

The control unit 18 controls processes performed by the electronic apparatus 1. For example, the control unit 18 may have a CPU (Central Processing Unit) and may control processes performed by the preprocessing unit 10, the image acquisition unit 12, the postprocessing unit 14, and the output unit 16. Moreover, the control unit 18 may also control imaging performed by the imaging optical system 3 according to imaging timing designated by the user interface.

The storage unit 20 stores data of the electronic apparatus 1. For example, the storage unit 20 may be a memory such as a DRAM (Dynamic Random Access Memory) or a storage such as an SSD (Solid State Drive). The storage unit 20 may be either a built-in memory or a memory such as a detachable memory card. Moreover, the storage unit 20 is not necessarily required to be included in an interior of the electronic apparatus 1, and may be an external storage connected via an input/output interface. Information is input to and output from the storage unit 20 at necessary timing in an appropriate manner for the electronic apparatus 1.

Some or all of the components described above may be provided on the same substrate. For example, the imaging optical systems 3, the preprocessing unit 10, the image acquisition unit 12, the postprocessing unit 14, the output unit 16, the control unit 18, and the storage unit 20 may be formed on one chip, or some of these components may be formed on a different chip in an appropriate manner. Moreover, part of the configuration formed on the same one-chip substrate may be laminated and formed on part of the configuration formed on a different substrate in the manufacturing step thereof, using a technology such as CoC (Chip on Chip), CoW (Chip on Wafer), and WoW (Wafer on Wafer).

Operations of the imaging optical systems 3 and the image acquisition unit 12 will be subsequently described in detail.

FIG. 5 is a diagram depicting the imaging optical systems 3 as viewed from the display surface side of the display unit 2. For example, the figure depicts a partial region of the display unit 2 as viewed from the display surface side. The display panel 4 is visible from the display surface. The display panel 4 has light emitting pixels 4b constituted by a plurality of light emitting elements and disposed in an array in the first direction and the second direction as indicated by dotted lines. Note that the arrangement, the orientation, and the like of the light emitting pixels 4b are presented only by way of example. The light emitting pixels 4b may be rotated by 45 degrees while being disposed in an arrangement similar to that in FIG. 5. Moreover, each of the light emitting pixels 4b is not limited to a square as depicted in the figure, and may be an oblong extended in any direction. In addition, each of the light emitting pixels 4b is not required to be rectangular.

Plural imaging optical systems 3 each having openings between the light emitting pixels 4b of the display panel 4 are provided. For example, FIG. 5 depicts a first imaging optical system 3A and a second imaging optical system 3B. As depicted in the figure by way of example, the first imaging optical system 3A has elliptical openings each having a major axis in the second direction and constituting a first optical system 9A, while the second imaging optical system 3B has elliptical openings each having a major axis in the first direction and constituting a second optical system 9B. As the optical system, a plurality of openings may be formed for each of the imaging optical systems. In FIG. 5, for example, first imaging units 8A are each provided below the opening formed in the corresponding first optical system 9A, while second imaging units 8B are each provided below the opening formed in the corresponding second optical system 9B. Note that other configurations may be adopted. Each of the imaging units 8 may be formed at a position deviating from the corresponding opening.

While not depicted in the figure, a lens may be provided as part of each of the optical systems 9 and disposed between the corresponding opening and the imaging unit 8 or at the opening such that light having passed through the opening is diffused or collected toward an imaging region of the imaging unit 8 in an appropriate manner. An optical system other than the lens may be provided so as to receive light at the imaging region of the imaging unit 8 in an appropriate manner. The opening herein refers to an optically transmissive region, and may be an air gap or may be filled with a transparent material such as a resin. Alternatively, the opening may be a material transmitting a particular wavelength using a color filter or the like. The material filling the opening is not particularly limited. For example, optical characteristics of the first optical systems 9A and the second optical systems 9B may be made different from each other by filling the openings with materials having different transmittances and refractive indexes.

Each of the imaging optical systems 3 has a different layout of openings located at different positions as the first imaging optical system 3A and the second imaging optical system 3B depicted in FIG. 5. The difference in the layout of the openings produces a different optical characteristic of each of the optical systems belonging to the respective imaging optical systems. Light enters the respective imaging units 8 from the display surface of the display unit 2 via different optical characteristics. Specifically, light enters the first imaging units 8A and the second imaging units 8B via different optical characteristics.

For example, as depicted in FIG. 5, the openings belonging to the respective imaging optical systems may be similar ellipses having different directions. In this manner, the optical systems 9 which generates diffraction images in different directions may be produced by forming openings having similar shapes but different directions.

Moreover, FIG. 5 depicts a state where two openings are formed in each of the first direction and the second direction and located between successive three light emitting pixels. However, other configurations may be adopted. For example, openings may be formed between a larger number of successive light emitting pixels. As described above, in the display unit 2 containing the display panel 4, one optical system 9 may not be necessarily one continuous region when viewed from the display surface, and may be a plurality of separate regions including openings cyclically disposed in spaces between the light emitting pixels, for example.

Further, the major axis of one opening corresponds to approximately two or three display pixels in FIG. 5. However, other configurations may be adopted. For example, each of the openings may have a longer major axis or a shorter major axis.

In addition, rather than similar openings, the major axis of the opening constituting part of the second optical system 9B may be longer or shorter than the major axis of the opening constituting part of the first optical system 9A so as to generate diffraction images having different characteristics. As described above, the respective openings have different layouts. In this manner, an effect of a flare on signals output from the first imaging optical system 3A can be made more different from an effect of a flare on signals output from the second imaging optical system 3B. Accordingly, this configuration can also support the operation performed by the image acquisition unit 12 for reducing flares. The effect of flares produced in this manner of layouts of the openings varies depending on a state of the electronic apparatus 1 or a state of each constituent element within the electronic apparatus 1, and therefore may be more appropriately defined by the design of the electronic apparatus 1.

Each of FIGS. 6A and 6B depicts an image obtained after conversion from analog signals acquired from the respective imaging optical system 3 depicted in FIG. 5 and coordinate adjustment. FIG. 6A is an image acquired on the basis of the first imaging optical system 3A, while FIG. 6B is an image acquired on the basis of the second imaging optical system 3B.

The image acquisition unit 12 may execute position adjustment. For example, an imaging position may be adjusted such that an image displayed on the display panel 4 and indicating mirror images of images acquired by the respective imaging optical systems 3 overlaps with a reflection image obtained by viewing the display surface from the front. For example, in a case where a human is located at such a position as to be reflected at the center of the display surface, the positions of the images acquired by the imaging optical systems 3 may be so adjusted as to be displayed at the center of the display surface. For example, correction may be made on the basis of positional deviation of the imaging optical systems 3 from the center of the display surface. Note that positional adjustment is not limited to this correction, and may be executed by any method as long as appropriate control is achievable.

For example, flares are generated as indicated by white regions in each of FIGS. 6A and 6B in the case where positional adjustment is made in the manner described above. For example, a flare is generated as a brighter region than an image actually desired to be captured as depicted in the figures.

In this case, the image acquisition unit 12 performs image correction by acquiring, in signals output from the first imaging optical system 3A and the second imaging optical system 3B, values of pixels indicating lower light intensity or lower luminance values after conversion into digital signals, to thereby reduce flares generated at different positions. Note that, in the case of processing for signals before conversion into digital signals, the preprocessing unit 10 may perform selection on the basis of intensity of each signal.

FIG. 7 depicts an image processed by the image acquisition unit 12 and output from the electronic apparatus 1. After the foregoing processing performed by the image acquisition unit 12, the postprocessing unit 14 adjusts brightness or the like, for example. By outputting the image processed in the manner described above, the flare is reduced as depicted in FIG. 7. In this manner, an image adjusted to natural brightness or the like is acquirable.

For example, the region where the flare is generated as depicted in each of FIGS. 6A and 6B is determined depending on each of the imaging optical systems 3 in some cases. Accordingly, the region where the flare is generated may be stored in the storage unit 20 or in the image acquisition unit 12 in advance. In this case, a process for selecting pixel values or a process for merging pixel values may be executed at a high speed. For example, an image associated with a certain pixel may be acquired on the basis of output from the predetermined imaging optical system 3 without the necessity of comparison of pixel values output from the respective imaging optical systems 3.

As described above, according to the present embodiment, reduction of flares is achievable in an image captured by the camera provided on the rear surface of the display unit of the display, i.e., the front camera disposed in such a position as to overlap with the display by designating different directions as diffraction light generation directions of the plural imaging optical systems. As a result, the imaging optical systems each capable of acquiring an accurate image can be provided on the front side of the display of the electronic apparatus without increasing the width of the bezel disposed on the surface where the display is provided.

For example, in a case where light generated from an intensive light source is partially applied to the surface of the display, a component of a flare is likely to be generated in the imaging optical system 3 close to the region to which this light is applied. Even in this case, a flare-reduced image is acquirable similarly to above by using an image acquired by at least one of the other imaging optical systems 3 provided at different positions.

Note that the first imaging optical system 3A and the second imaging optical system 3B are two imaging optical systems selected from the plurality of imaging optical systems. Three or more imaging optical systems 3 may be provided. Specifically, operations and effects of the present embodiment and embodiments to be described below can be offered if at least two imaging optical systems 3 included in the three or more imaging optical systems 3 function as the first imaging optical system 3A and the second imaging optical system 3B. Moreover, the degree of freedom in acquiring captured images can further be raised by providing two pairs or more of imaging optical systems having the characteristics of the pair of the first imaging optical system and the second imaging optical system described above as imaging optical systems included in the three or more imaging optical systems 3. Accordingly, accuracy of flare reduction can improve. In this case, the same imaging optical system may be included in different combinations as long as these combinations are not defined as the same combination. For example, in a case where 3X, 3Y, and 3Z are provided as imaging optical systems, two sets of combinations (3X, 3Y) and (3X, 3Z) each containing the common X may be each adopted as a combination of (first imaging optical system, second imaging optical system).

Moreover, it is assumed in the above description that each of the imaging optical systems 3 has the openings constituting the optical systems 9. However, other configurations may be adopted. For example, in a different adoptable configuration, one of the imaging optical systems 3 has an opening, while the other has no opening. In this case, flares located at different positions are generated from the plural imaging optical systems 3 similarly to the case described above. Accordingly, an effect of flares can be reduced by using images acquired from the plurality of imaging optical systems 3.

Moreover, it is assumed that each of the openings has an elliptical shape. However, other configurations may be adopted. For example, each of the openings may have a rectangular shape, or a rectangular shape having rounded corners. Alternatively, each of the openings may be formed by using any closed curve allowing appropriate light reception at the imaging unit 8. Moreover, the respective openings are not required to have the same shape in the thickness direction of the openings, i.e., in the third direction. For example, each of the openings may have a more complicated shape, such as a shape having a rectangular portion near the display surface and an elliptical portion near the imaging unit 8.

Further, while the shape or the like of the openings has been described above as the optical characteristic, other configurations may be adopted. For example, a different characteristic may be produced by changing a material or the like filling the inside of the openings for each of the imaging optical systems 3. In addition, each of the optical systems 9 may include a λ/4 wavelength plate, for example. In this case, p-waves may be cut off so as to reduce a flare generated by an effect of reflection within the display panel 4. Different types of wavelength plates may be provided as the optical systems 9 for the plural imaging optical systems 3. In this case, an effect of a flare generated by reflection, diffraction, or the like at the display unit 2 can be varied for each of the imaging optical systems 3. Accordingly, various types of methods for image correction are applicable.

### (Second embodiment)

An electronic apparatus according to the present embodiment which is not encompassed by the wording of the claims includes plural imaging optical systems each capable of reducing an effect of a flare by using openings having a similar layout.

FIG. 8 depicts the display surface of the electronic apparatus 1 according to the present embodiment depicted in a manner similar to the manner of FIG. 5. According to the present embodiment, each of the first imaging optical system 3A and the second imaging optical system 3B has a similar opening layout. On the other hand, unlike the first embodiment, the first imaging optical system 3A and the second imaging optical system 3B are located at different positions in the second direction. Specifically, each of the optical systems has elliptical openings each having a major axis in the second direction, and is disposed at a position deviating in the second direction.

FIG. 9 depicts an image acquired by the second imaging optical system 3B. For example, it is assumed that an image acquired by the first imaging optical system 3A is the image depicted in FIG. 6A. As described above, both of the imaging optical systems 3 have the elliptical openings having the major axis in the second direction. Accordingly, flare generation directions are aligned with each other. However, in the arrangement that the first imaging optical system 3A and the second imaging optical system 3B deviate from each other in the second direction, the flares are generated at positions deviating from each other in the second direction.

Accordingly, similarly to the first embodiment described above, the image acquisition unit 12 is capable of acquiring an image less affected by a flare. Moreover, the first imaging optical system 3A and the second imaging optical system 3B may deviate from each other also in the first direction. In the case of deviation in both the first direction and the second direction, center points of flares generated in the respective imaging optical systems are located at different positions in the first direction. Accordingly, a more desirable flare-reduced image is acquirable.

### (Third embodiment)

An electronic apparatus having three imaging optical systems will be described in the present embodiment.

FIG. 10 is a diagram depicting an example of the electronic apparatus 1 according to the present embodiment. The electronic apparatus 1 includes the first imaging optical system 3A, the second imaging optical system 3B, and a third imaging optical system 3C disposed on the side opposite to the display surface of the display unit 2. For example, these imaging optical systems are arranged in the first direction. The first imaging optical system 3A may be located substantially at the center of the screen, and the second imaging optical system 3B and the third imaging optical system 3C may be located in the vicinity of ends (boundary) of the display surface of the display unit 2 in such a manner that the first imaging optical system 3A is sandwiched between the second imaging optical system 3B and the third imaging optical system 3C. The vicinity may be defined as a range of one pixel to several pixels of display elements from the ends or the boundary, for example, or may be defined, in other examples, as a range of several millimeters from ends of the housing of the electronic apparatus 1, or a range of several percentages of the width or the height of the electronic apparatus 1.

This arrangement can equalize disparity between the first imaging optical system 3A and the second imaging optical system 3B with disparity between the third imaging optical system 3C and the first imaging optical system 3A. Specifically, in this manner, an image having disparity of (substantially) zero from the first imaging optical system 3A can be formed using an image acquired by the second imaging optical system 3B and an image acquired by the third imaging optical system 3C.

Even if pixels are distorted at the ends of the display surface, this distortion has only a small effect on the user. Accordingly, the foregoing arrangement is applied. On the other hand, for example, the size of the first imaging optical system 3A located near the center of the display surface may be made smaller than each size of the other imaging optical systems. The size herein may be either the size of the opening or the size of the imaging unit 8. In this arrangement, an image displayed by the display unit 2 becomes more natural.

For example, the first imaging optical system 3A in FIG. 10 may include an ellipse constituting the optical system 9 and having a major axis in the first direction, while each of the second imaging optical system 3B and the third imaging optical system 3C may include an ellipse constituting the optical system 9 and having a major axis in the second direction.

FIG. 11 is a diagram depicting images acquirable from the respective imaging optical systems in the case where the foregoing openings are formed. The images in the figure are acquired by the first imaging optical system 3A, the second imaging optical system 3B, and the third imaging optical system 3C in this order from the upper side. As apparent from the figure, a flare generated in the first imaging optical system 3A extends in the second direction, while flares generated in the second imaging optical system 3B and the third imaging optical system 3C deviate from each other in the first direction.

FIG. 12 is an image formed by overlaying the image of the second imaging optical system 3B and the image of the third imaging optical system 3C in consideration of disparity. By acquiring the flare-reduced image in consideration of disparity in this manner, the flare is allowed to shift to each of the ends as depicted in FIG. 12, for example. By using this image and the image in the uppermost stage in FIG. 11, a flare-reduced image as depicted in FIG. 7 is acquirable, for example. Merging or correction of these images may be executed by the image acquisition unit 12.

In the above description, the second imaging optical system 3B and the third imaging optical system 3C are located particularly at one and the other ends, respectively. However, other configurations may be adopted. For example, even if the second imaging optical system 3B and the third imaging optical system 3C are provided at positions at each of which equivalent disparity appears with the first imaging optical system 3A interposed between the second imaging optical system 3B and the third imaging optical system 3C, acquisition of a flare-reduced image can be similarly executed. Moreover, while deviation is assumed in the first direction in the present embodiment, deviation may be assumed in the second direction. Furthermore, the respective imaging optical systems 3 may be disposed at positions deviating in both the first direction and the second direction.

### (Fourth embodiment)

Intensity of a flare may vary depending on the direction where the flare is generated. For example, an intense flare may be generated in the first direction, but a weak flare may be generated in the second direction. For handling this case, according to the present embodiment, an imaging optical system likely to generate a flare in the first direction or the second direction is selected in an appropriate manner to acquire a flare-reduced image on the basis of a signal acquired from the selected imaging optical system.

For example, FIG. 13 depicts an example of an image acquired on the basis of output from the first imaging optical system 3A in a case where the imaging optical systems depicted in FIG. 5 are used for acquisition the image. In this case, an intense flare is generated in the second direction, but a flare not so intense is generated in the first direction. As depicted in FIG. 13, the flare generated in the first direction is less intense. Accordingly, an image containing a dark flare portion is acquired in comparison with FIG. 6A. On the other hand, the flare generated in the second direction is intense. Accordingly, the image output and acquired from the second imaging optical system 3B is an image containing a bright flare portion as depicted in FIG. 6B.

As described above, in the case where intensity of a flare varies depending on the direction, a flare-reduced image may be acquired on the basis of output from the first imaging optical system 3A. For example, the preprocessing unit 10 calculates variances of luminance in the first direction and the second direction in image data output from the respective imaging optical systems 3 to obtain flare intensity. For example, an average value is obtained by calculating variances in the first direction for each row, and an average value is obtained by calculating variances in the second direction for each column. The direction corresponding to the high average value may be considered as a direction where an intense flare is generated. Alternatively, the direction may be determined on the basis of not variances but a difference between maximum luminance and minimum luminance for each row or column.

In which direction each of the imaging optical systems 3 is likely to generate a flare is dependent on the optical system 9 of the corresponding imaging optical system 3 as described above. For example, this direction is determined on the basis of the direction of the openings formed in the optical system 9 as described above. The imaging optical system 3 used with priority in the case of generation of a flare in any direction may be determined in advance on the basis of the direction of the openings.

While likeliness of flare generation depending on the layout of the openings has been described, other configurations may be adopted. For example, the optical system for flare control may include not only the layout of the openings but also the whole display panel including wiring of circuits. Flares and diffraction shapes also vary depending on a type of patterns cyclically arranged on the circuits and a manner of interference by light. The direction where a flare is likely to be generated may be determined in consideration of this point as well.

The image acquisition unit 12 acquires a flare-reduced image by using the imaging optical system 3 having a priority direction different from a direction where a flare is generated. For example, in a case where the images depicted in FIG. 13 and FIG. 6B are output via the corresponding imaging optical systems 3, the image in FIG. 13 containing less flare generation may be selected and output. Moreover, a weighted average may be calculated using the weighted image in FIG. 13 and the image in FIG. 6B.

In another example, in a case where an intense flare is generated in the second direction, an image may be acquired by any one of the above-mentioned acquisition methods (e.g., selection, merging) by using the plurality of the imaging optical systems 3 each designating the first direction as a priority direction.

As described above, in a case where a flare has polarity, a flare-reduced image may be acquired on the basis of an image output from the imaging optical system 3 designating a direction different from the direction of the polarity as a priority direction.

### (Fifth embodiment)

According to the electronic apparatus 1 of the present embodiment, any of the imaging optical systems 3 is disposed in such a position as to reduce flare generation even in the case of flare generation.

FIG. 14 is a diagram depicting a cross section of the electronic apparatus 1 according to the present embodiment. As depicted in FIG. 14, the electronic apparatus 1 includes a light shield 30 between plural imaging optical systems 3. The light shield 30 may be a light shielding film including a material having a high light shielding effect, or an absorbing film including a material having a high light absorption rate.

As described above, the light shield 30 preventing propagation of light between the imaging optical systems 3 may be provided on the side opposite to the display surface of the display panel 4.

FIG. 15 depicts another example. In this example, the light shield 30 may be so provided as to prevent propagation of light, which has been reflected on the display panel 4 and the circularly polarizing plate 5, in the first direction and the second direction toward the plurality of the imaging optical systems 3.

FIG. 16 depicts a further example. In this example, the light shield 30 may be so provided as to penetrate the display panel 4. The light shield 30 provided in this manner can shield not only light reflected on the display unit 2 but also light reflected on parts other than the display unit 2.

For example, as depicted in FIGS. 15 and 16, the light shield 30 disposed in the region containing the display panel 4 and the circularly polarizing plate 5 can reduce flare generation caused by light reflected or diffracted, for example, in these layers. Even in a state where an intense flare is generated at the imaging optical system 3 which receives light from a certain region where an intense flare is generated as a result of incident light or the like, an effect of this flare can be reduced at another imaging optical system 3 separated by the light shield 30.

Moreover, for example, an effect between the respective imaging units 8 can be reduced by decreasing an effect of light reflection or diffraction on the side opposite to the display surface of the display unit 2 in the third direction as depicted in FIGS. 14 and 16.

While the case of the light shield 30 reaching the circularly polarizing plate 5 has been described above, a configuration having the light shield 30 also in the touch panel 6 may be adopted, for example. Moreover, the light shield 30 having a sufficiently reduced thickness may be formed to reach the inside of the region of the cover glass 7. In this case, appropriate size adjustment and positioning may be made so as to present the display of the display unit 2 on the display surface to the user as a natural image. Furthermore, this case may be handled in terms of software in the display panel 4, such as raising luminance of the light emitting pixels 4b disposed around the light shield 30 higher than luminance of the other light emitting pixels 4b.

In this manner, light shielding is provided between the plural imaging optical systems 3 even in the case of flare generation. Accordingly, even in the case where an intense flare is generated in one of the imaging optical systems 3, an image less affected by a flare can be acquired using the other imaging optical system 3. For example, the image acquisition unit 12 can acquire an image less affected by a flare by comparing or merging output values received from the plurality of imaging optical systems 3 similarly to the embodiments described above.

### (Seventh embodiment)

According to the respective embodiments described above, the image acquisition unit 12 acquires an image less affected by a flare on the basis of predetermined calculation (including comparison). On the other hand, according to the present embodiment, a flare-reduced image is acquired by merging outputs from the plurality of imaging optical systems 3 with use of a model.

For example, the model may be a statistical model. A model may be generated beforehand by statistical calculation to determine what calculation is to be used for merging for the various types of imaging optical systems 3. Thereafter, the image acquisition unit 12 may input information acquired from the plurality of imaging optical systems 3 to this model to acquire an image less affected by a flare.

For example, the model may be a neural network model trained by deep learning. The neural network model may be created using MLP (Multi-Layer Perceptron), CNN (Convolutional Neural Network), or the like. In this case, parameters trained on the basis of a plurality of pieces of teacher data may be stored in the storage unit 20 or the image acquisition unit 12 beforehand, and the image acquisition unit 12 may create a neural network model based on the stored parameters. The image acquisition unit 12 may acquire a flare-reduced image by using the created and trained model on the basis of data output from the plurality of imaging optical systems 3.

Moreover, in the case of use of the trained model, the electronic apparatus 1 may further improve training accuracy by using a captured image. For example, training may be executed by the control unit 18 or the like of the electronic apparatus 1. In another example, training may be executed at a server or the like after data is transmitted from a plurality of electronic apparatuses 1 to a storage or the like present in a cloud or the like. Thereafter, re-trained parameters may be reflected in the electronic apparatuses 1. In this case, only information indicating a flare may be transmitted so as to exclude privacy information containing user face information. Moreover, transmission and reception of data to and from the electronic apparatus 1 may be brought into a state selectable by the user using an opt-in method or an opt-out method, for example.

In this manner, the image acquisition unit 12 may acquire an image by performing not only linear processing, but also non-linear processing, particularly calculation or the like using various types of models including a trained model.

### (Eighth embodiment)

According to the embodiments described above, the image acquisition unit 12 acquires an image by merging or the like of images on the basis of pixel values or priority directions, or the method using a model. In the present embodiment, each of the imaging optical systems 3 limits a region where image correction is executed.

For example, as depicted in FIG. 6A and others, a region where a flare is generated in each of the imaging optical systems 3 is often determined with a bright object as a bright spot. This tendency comes from the characteristics of the optical systems 9 of the respective imaging optical systems 3, positions of the imaging optical systems 3, or the like. Accordingly, in the case where a bright object is present, the image acquisition unit 12 can predict a region where a flare is to be generated in each of the imaging optical systems 3, and therefore may correct an image on the basis of a prediction result thus obtained.

A flare is often generated by an adjacent optical element. In this case, disparity produced in images acquired by the plurality of imaging optical systems 3 is highly likely to be larger than disparity of other objects. Accordingly, disparity may be calculated using the image acquisition unit 12 or the like, and a region having large disparity may be predicted as a region where a flare is generated.

For correction, in a region where a flare is highly likely to be generated in one of the imaging optical systems 3, pixel values are determined on the basis of information acquired from the other imaging optical system 3, for example. An interpolation process for this region on the basis of the other imaging optical system 3 may be executed, for example, in place of the comparison calculation described in the first embodiment. Alternatively, a correction process may be performed on the basis of other calculation such as weighted calculation performed such that an effect of pixel values output from the other imaging optical system 3 increases.

Moreover, in a case where three or more imaging optical systems 3 are provided and a flare generation probability in this region is low in the other plurality of imaging optical systems 3, an image less affected by a flare may be acquired on the basis of information obtained from the other plurality of imaging optical systems 3.

In addition, this region may be reflected in the trained model of the embodiment described above for update. By this reflection as training, correction accuracy can improve between different users having the same electronic apparatus 1, for example.

Moreover, in a further example, this region may be determined by introducing light without display on the display panel 4, for example. The region may be predicted by illuminating the display panel 4 with intensity sufficient for generating a flare instead of no display on the display panel 4. In this manner, a process for determining a region where a flare is generated may be performed not at imaging timing desired by the user, but at other timing, such as timing before and after imaging. This process may be executed by the control unit 18 or the image acquisition unit 12, for example.

### (Ninth embodiment)

According to the present embodiment, the electronic apparatus 1 includes a micro-lens array as the optical system 9 of each of the imaging optical systems 3.

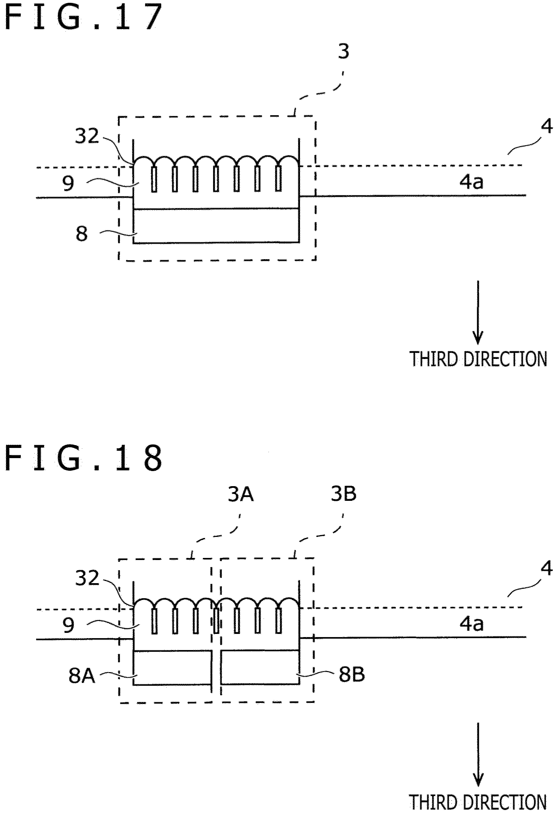

FIG. 17 is a diagram depicting the imaging optical system 3 according to the present embodiment. The optical system 9 of the imaging optical system 3 includes a micro-lens array 32. Light having passed through the micro-lens array 32 enters the imaging unit 8 in an appropriate manner and is converted into a signal and output from the imaging unit 8.

The preprocessing unit 10 may reconstitute an image on the basis of the signal output from the imaging unit 8. The image acquisition unit 12 acquires an image less affected by a flare on the basis of this reconstituted image, according to the respective embodiments described above.

FIG. 18 is a diagram depicting the imaging optical systems 3 in another example of the present embodiment. Each of the first imaging optical system 3A and the second imaging optical system 3B includes the common micro-lens array 32 as the optical system 9. In this case, each of lights collected from respective lenses of the micro-lens array 32 enters a certain limited region. Accordingly, the imaging unit 8 may be disposed for each of these limited regions to provide the plurality of imaging optical systems 3. In this case, for example, the light shield 30 explained in the fifth embodiment may be provided between the first imaging unit 8A and the second imaging unit 8B. While the two imaging optical systems are provided in FIG. 18, other configurations may be adopted. Three or more imaging optical systems 3 may be provided for the same micro-lens array 32.

### (Tenth embodiment)

According to the configuration of the embodiment described above by way of example, a plurality of imaging units 8 is provided for the same micro-leys array 32. In the electronic apparatus 1 of the present embodiment, however, the same imaging unit 8 is provided for a plurality of the optical systems 9.

FIG. 19 is a diagram depicting an example of the imaging optical systems 3 according to the present embodiment. The electronic apparatus 1 includes one imaging unit 8 for the first imaging optical system 3A and the second imaging optical system 3B. A first imaging unit 8A and a second imaging unit 8B are defined in a region allowing imaging in the imaging unit 8. Light having passed through the first optical system 9A enters the first imaging unit 8A, while light having passed through the second optical system 9B enters the second imaging unit 8B. In this manner, the plurality of optical systems 9 may be provided for the same imaging unit 8 to form the plurality of imaging optical systems 3.

FIG. 20 is a diagram depicting another implementation example of the present embodiment. Specifically, the micro-lens array 32 may be provided as the optical system 9, and the same micro-lens array 32 and the imaging unit 8 may be provided to constitute the first imaging optical system 3A and the second imaging optical system 3B.

FIG. 21 depicts a modification example of FIG. 20. In this example, the light shield 30 is provided between the first imaging optical system 3A and the second imaging optical system 3B. By providing the light shield 30 in this manner, each of lights entering respective regions of the imaging unit 8 is more definitely controllable.

FIG. 22 depicts a modification example of FIG. 19. In this mode, the light shield 30 is provided between the first optical system 9A and the second optical system 9B. By providing the light shield 30 in this manner, each of light entering the first imaging unit 8A and light entering the second imaging unit 8B is more definitely controllable even in a case where the micro-lens array 32 is not used.

Note that the light shield 30 does not pass through the display panel 4 in each of FIGS. 21 and 22. However, needless to say, the light shield 30 may be provided in such a manner as to pass through the display panel 4, or penetrate the display panel 4 as depicted in the example of FIG. 16.

As described above, the imaging unit 8 may be provided as a common component for the plurality of imaging optical systems 3 to simplify the circuit configuration of the imaging unit 8 and the semiconductor process.

For example, some or all of the components can be the same elements, to thereby integrate the plurality of imaging optical systems 3 as described in the present embodiment. By integrating and arranging the plurality of imaging optical systems 3 in the manner described above, an effect of disparity between the imaging optical systems 3 can also be reduced. In this manner, the effect of disparity can be reduced even in the case of correction of images acquired from each of these. Accordingly, correction accuracy can improve.

Moreover, the plurality of imaging optical systems 3 may be integrated such that the optical systems 9 are disposed adjacent to each other in the configurations of the respective embodiments described above, rather than providing the imaging unit 8 or the optical system 9 as a common component as in the present embodiment. In this case, accurate correction is similarly executable after reduction of the effect of disparity.

FIG. 23A is a diagram depicting another arrangement example of the micro-lens array 32. As depicted in FIG. 23A herein, the micro-lens array may be disposed within an opening of the optical system 9 on the side near the imaging unit 8. In this manner, the optical system 9 may include the opening and the micro-lens array 32 as different components. Needless to say, the opening is not necessarily required. The optical system 9 may be formed by arranging the micro-lens array 32 on the side opposite to the surface of the display panel 4.

FIG. 23B is a diagram depicting a further example of the arrangement of the micro-lens array 32 and the arrangement of the display panel 4. One or a plurality of micro-lens arrays 32 may be provided for a plurality of openings. In this case, the openings may be formed leaving an appropriate region for the light emitting pixels of the display panel 4, and the micro-lens array 32 may be provided between lower parts of these openings and the imaging unit 8.

Needless to say, the light shield 30 may be provided at an appropriate position in each of the cases of FIGS. 23A and 23B.

### (Eleventh embodiment)

A chip configuration of the imaging unit 8 and the like will be described in the present embodiment.

FIG. 24 depicts an example of a chip configuration according to the present embodiment. This configuration is a schematic illustration of an example imposing no limitation, and does not exclude such a configuration which provides other functions on this chip. Specifically, a selector, an I/F, a power source node, and the like are appropriately provided as well as components depicted in the figure.

As depicted in FIG. 24, an analog circuit such as the preprocessing unit 10, and a logic circuit such as the image acquisition unit 12 may be provided on the same chip where the imaging unit 8 is provided. Moreover, the control unit 18 and the storage unit 20 may be provided on the same chip. By providing the imaging unit 8, the preprocessing unit 10, and the image acquisition unit 12 on the same chip as described above, data processing can be executed at a high speed while reducing signal deterioration without requiring an interface for signal and data transmission and reception.

Moreover, the preprocessing unit 10 is not required to be a common component, and may be provided for each of the imaging units 8. In this case, adoptable is such a configuration which transmits digital image data from the respective preprocessing units 10 to the image acquisition unit 12.

FIG. 25 is a diagram depicting another example of the chip configuration. FIG. 25 does not depict configurations other than the imaging units 8, the preprocessing unit 10, the image acquisition unit 12, and the interface. The respective imaging units 8 may be provided on separate chips. One of the imaging units 8 is provided on one chip, while another imaging unit 8 is similarly provided on the other chip. The imaging unit 8 on the one chip includes a reception interface 22 provided for transmission to the other chip.

The other chip receives a signal via the reception interface 22, and the image acquisition unit 12 acquires an image together with the signal transmitted from the imaging unit 8 provided on this chip. The preprocessing unit 10 executes signal processing before output of data to the image acquisition unit 12 as necessary. The preprocessing unit 10 may be provided on both of the chips or may be provided only on the other chip.

Needless to say, the number of chips on which the imaging units 8 are provided is not limited to two. A larger number of imaging units 8 may be provided on more separate chips. This configuration also achieves reduction of a chip area associated with the imaging unit 8 even in a case where the imaging optical systems 3 are disposed at various positions on the side opposite to the display surface of the display unit 2.

FIG. 26 depicts a still further example, presenting a configuration including plural imaging units 8 provided on separate chips, and the image acquisition unit 12 provided on a further different chip. In this manner, the logic circuit for processing digital signals and the photoelectric conversion circuit containing the light receiving elements can be constituted on different chips. This configuration can further increase the degree of freedom of the arrangement or the like of the imaging optical systems 3 without considerably enlarging the chip area.

The reception interface 22 in each of FIGS. 24 to 26 may be an interface capable of executing data reception under MIPI standards, for example. Moreover, the reception interface 22 may be of a type capable of achieving high-speed transfer under other standards. The reception interface 22 may be of either a type transmitting and receiving analog signals or a type transmitting and receiving digital signals, depending on signals to be transmitted. The type of the interface is appropriately selectable according to chip implementation of the imaging unit 8 and the preprocessing unit 10.

### (Twelfth embodiment)

While the light emitting pixels 4b of the display panel 4 have not been particularly touched upon in the respective embodiments described above, the light emitting pixels 4b may be configured to change flare generation of the plurality of imaging optical systems 3 and allow acquisition, using the image acquisition unit 12, of an image less affected by a flare.

For example, in the case where two imaging optical systems 3, i.e., the first imaging optical system 3A and the second imaging optical system 3B, are provided, the light emitting pixels 4b provided around the first imaging optical system 3A may be of a type different from the type of the light emitting pixels 4b around the second imaging optical system 3B. For example, one of the types may be an OLED while the other type may be a MicroLED. By providing different types of light emitting elements in the manner described above, particularly providing display optical systems having different optical characteristics, a characteristic of an effect of a flare to be generated can be varied.

When each flare is generated via a different optical characteristic, flare generation in each of images acquired from the respective imaging optical systems 3 differs depending on situations. In the state where each flare has a different characteristic, an image considerably affected by a flare is acquired from one of the imaging optical systems 3, while an image less affected by a flare is acquired from the other imaging optical system 3, for example. By using the light emitting elements having different characteristics in the manner described above, the application range of the methods performed by the image acquisition unit 12 for merging and correction of images is expandable to a variety of methods.

### (Thirteenth embodiment)

According to the respective embodiments described above, an image less affected by a flare is acquired using images output from the plurality of imaging optical systems 3. Specifically, the plurality of imaging optical systems 3 is first started, and then an image is acquired on the basis of information acquired from the respective imaging optical systems 3. According to the present embodiment, at least one imaging optical system 3 is started according to the necessity of reducing an effect of a flare. For example, at least one imaging optical system 3 is provided as a system started in the case where image correction is necessary.

For example, only the imaging optical system 3 present in the vicinity of the center of the display surface may be started in an initial stage. In the case of determination that reduction of an effect of a flare is needed on the basis of the image acquired by the imaging optical system 3, another imaging optical system 3 may be started to acquire, using the image acquisition unit 12, an image less affected by the flare.

For example, it may be determined that a considerable effect of a flare is produced in a case where intense light is applied to the whole or only part of the region of the display surface. Alternatively, an effect of a flare may be determined on the basis of other conditions. While the foregoing determination is made on the basis of an output from one imaging optical system 3, other configurations may be adopted. For example, the determination may be made on the basis of the magnitude of signals received from several light emitting elements. Moreover, in another example, the determination may be made on the basis of a distribution of luminance or the like of an image displayed on the display panel 4. In this manner, an effect of a flare is determined using various types of determination methods.

On the basis of this determination, the control unit 18 causes the appropriate imaging optical system 3 to operate, and acquires a signal based on incident light and an image by using the image acquisition unit 12. The control unit 18 may also execute the above determination of an effect of a flare. In this manner, at least part of the imaging optical systems 3 can be operated as necessary to achieve power saving.

### (Fourteenth embodiment)

According to the respective above embodiments, various implementations of the imaging optical systems 3 and the image acquisition unit 12 have been described. In the present embodiment, the arrangement of the imaging optical systems 3 will be described.

Each of FIGS. 27 to 31B is a diagram depicting an arrangement example of the imaging optical systems 3 as viewed from the display surface. Each of these figures presents an arrangement by way of example. The arrangement is not limited to the examples depicted in the figures. Moreover, an arrangement including part or the whole of the arrangement depicted in each of the plural figures may be adopted. Specifically, the electronic apparatus 1 may include not only the imaging optical systems 3 depicted in one of the figures, but also three or more imaging optical systems 3 having multiple characteristics depicted in the plurality of figures.

As depicted in FIG. 27, the imaging optical systems 3 may be provided at both ends (around the boundary) in any of directions of the display screen 1a, such as the first direction. This arrangement allows the imaging optical systems 3 to be provided at positions inconspicuous for the user. Alternatively, the imaging optical systems 3 may be provided at both ends in the second direction, i.e., at upper and lower ends in FIG. 27.

As depicted in FIG. 28, two imaging optical systems 3 may be provided away from each other by 50 to 80 mm in the display screen 1a. This arrangement allows acquisition of images having disparity close to disparity of both eyes of a human from the two imaging optical systems 3. In this manner, an effect of a flare in each of the plural imaging optical systems 3 can be reduced, and also a stereo image giving a natural impression to a human can be formed. Moreover, the third imaging optical system 3 may be provided at a different position to acquire a flare-reduced image which has disparity produced by the third imaging optical system 3 and the two imaging optical systems 3. In this manner, a stereo image with improved flare reduction accuracy can be acquired.

As depicted in FIG. 29, the plural imaging optical systems 3 may be so disposed as to deviate in each of the first direction and the second direction. For example, an opening having a major axis in the same direction may be formed in each of the optical systems 9 to acquire an image containing a flare having a center shifted in both the first direction and the second direction. In this manner, a highly accurate flare-reduced image can be acquired even by a simpler process (e.g., the comparison process and the selection process in the first embodiment) using the image acquisition unit 12.

As depicted in FIG. 30, three or more imaging optical systems 3 may be provided. In the case where the three or more imaging optical systems 3 are provided, an asymmetrical arrangement may be adopted as depicted in FIG. 30, or an arrangement having some symmetry with respect to the first direction, the second direction, the center point, or the like may be adopted. Moreover, the third imaging optical system 3 may be disposed at a position away from the other two imaging optical systems 3. In this case, intensity of a flare corresponding to the position may also be varied for each of the imaging optical systems 3.

Each of FIGS. 31A and 31B depicts the same electronic apparatus 1. FIG. 31B is an external diagram as viewed in a direction of an arrow in FIG. 31A. In this manner, a plurality of the display screens 1a may be provided. The imaging optical systems 3 in each of the display screens may be disposed at equivalent positions toward the display screen 1a as depicted in these figures, or may be disposed at completely different positions. For example, at least two imaging optical systems 3 may be disposed at one and the other ends of the front surface in the first direction, while at least two imaging optical systems 3 may be disposed at one and the other ends of the rear surface in the second direction. In this case, for example, the imaging optical systems 3 depicted in FIG. 31B may be used as rear cameras in a normal state, and may be utilized as twin-lens rear cameras (or cameras having a larger number of lenses).

In this manner, the imaging optical systems 3 may be disposed at various positions on the display screen 1a.

As presented in the respective embodiments described above, at least two of the plurality of imaging optical systems 3 are only required to be provided at different positions. The arrangement is not limited to the arrangements depicted in the figures or the like, and may be freely selected. For example, the plural imaging optical systems 3 disposed at different positions in the first direction may be provided in the vicinity of the center of the display screen in the second direction, in FIG. 2 or other figures, to acquire an image or a video corresponding to a natural visual line of the user viewing a region near the center of the screen. Moreover, instead of this arrangement, the imaging optical systems 3 may be provided slightly above in the second direction, for example. For acquiring an image of the user's face, for example, the imaging optical systems may be disposed such that the center of the face comes to the vicinity of the center of the screen, and that the imaging optical systems come to the vicinity of the displayed eyes. Moreover, in an arrangement different from the above, the imaging optical systems may be provided in a similar manner in the second direction in the vicinity of the center in the first direction. In this case, a similar image can be acquired even after rotation of the screen.

Another example of the layout of openings included in the optical systems 9 will be subsequently described. A more complicated layout may be adopted rather than a simple shape as depicted in FIG. 5 or 8 or other figures.

Each of FIGS. 32 to 35 is a diagram depicting an example of the layout of openings. As depicted in FIG. 32, for example, the openings may be disposed at positions deviating from the display elements also in the second direction.

As depicted in FIG. 33, for example, each of the openings may be formed between the display elements and have a shape of a combination of an ellipse having a major axis in the first direction and an ellipse having a major axis in the second direction.

As depicted in FIG. 34, for example, the openings belonging to the first optical system 9A and the openings belonging to the second optical system 9B need not cross each other at angles close to 90 degrees. For example, in this case, the angles of the light emitting elements of the display panel 4 may also be partially changed. For example, the angle of the light emitting elements included in any one of the optical systems 9 and located near the display surface in the third direction may be rotated by 45 degrees or any significant angle.

Needless to say, as depicted in FIG. 35, the openings depicted in FIG. 33 may be arranged as depicted in FIG. 34.

In this manner, the openings constituting part of the optical systems 9 may be arranged in such a layout that a flare is generated significantly in a different direction. In a case where the electronic apparatus 1 includes three or more imaging optical systems 3, the layouts of the openings depicted in FIGS. 5, 8, and 32 to 35 may be combined. In this case, the direction of flare generation further becomes a combination of various directions depending on the imaging optical systems 3. Accordingly, the range of image acquisition, such as image correction, merging, and selection, can be further widened, for example.

As described above, according to the respective embodiments, the imaging optical systems 3 are disposed on the side opposite to the display surface of the display unit 2, and light passing through the display unit 2 is acquired by the plurality of imaging units 8. Part of light passing through the display unit 2 is repeatedly reflected within the display unit 2 and then enters the imaging units 8 in the plurality of imaging optical systems 3. According to the respective embodiments described above, an image is acquired from signals obtained by the plurality of imaging optical systems 3. Accordingly, a captured image can be formed while easily and reliably reducing flare components or diffraction light components contained in the light having entered the plurality of imaging units 8 (including the integrated imaging units 8) after repeated reflection within the display unit 2.

Moreover, for example, the processes performed by the image acquisition unit 12 and the like may be implemented by digital circuits, or programmable circuits such as FPGA (Field Programmable Gate Array). Furthermore, processing contents may be described in a program, and information processing performed by software may be specifically achieved using hardware resources such as a CPU.

Several application examples will be hereinafter presented.

### (Fifteenth embodiment)

There are various types each considered to be a specific candidate for the electronic apparatus 1 having the configurations described in the above embodiments. For example, FIG. 36 is a plan diagram in a case where the electronic apparatus 1 of the respective embodiments is applied to a capsule endoscope 50. The capsule endoscope 50 depicted in FIG. 36 includes a camera (ultraminiature camera) for capturing an image of an inside of a body cavity, a memory 53 for recording image data captured by the camera 52, and a wireless transmitter 55 for transmitting recorded image data to the outside via an antenna 54 after the capsule endoscope 50 is discharged to the outside of the body of an examinee. All the components 52 to 55 are included in a housing 51 having semispherical shapes at both end surfaces and a cylindrical shape at a central portion, for example.

Moreover, a CPU (Central Processing Unit) 56 and a coil (magnetic force and current conversion coil) 57 are provided within the housing 51. The CPU 56 controls imaging using the camera 52 and an operation for data accumulation in the memory 53, and controls data transmission from the memory 53 to a data reception device (not depicted) outside the housing 51 by using the wireless transmitter 55. The coil 57 supplies power to the camera 52, the memory 53, the wireless transmitter 55, the antenna 54, and light sources 52b described below.

Moreover, a magnetic (lead) switch 58 is provided in the housing 51 to detect when the capsule endoscope 50 is set on the data reception device. At the time when the lead switch 58 detects this setting on the data reception device and data transmission is allowed, the CPU 56 supplies power from the coil 57 to the wireless transmitter 55.

For example, the camera 52 has an imaging element 52a including the optical system 9 for capturing an image of the inside of the body cavity, and the plurality of light sources 52b for illuminating the inside of the body cavity. Specifically, for example, the camera 52 includes a CMOS (Complementary Metal Oxide semiconductor) sensor including an LED (Light Emitting Diode), a CCD (Charge Coupled Device), or the like to function as the light sources 52b.

The display unit 2 included in the electronic apparatus 1 of the above embodiments is a concept containing a light emitter such as the light sources 52b depicted in FIG. 36. The capsule endoscope 50 in FIG. 36 has two light sources 52b, for example. The light sources 52b may include the display panel 4 having a plurality of light source units or an LED module having a plurality of LEDs. In this case, limitations imposed on the layout arrangement of the camera 52 can be reduced by arranging the imaging units 8 of the camera 52 below the display panel 4 or the LED module. Accordingly, the capsule endoscope 50 can be made more compact.

### (Sixteenth embodiment)

Furthermore, FIG. 37 is a rear diagram in a case where the electronic apparatus 1 of the embodiments described above is applied to a digital single lens reflex camera 60. The digital single lens reflex camera 60 or a compact camera includes the display unit 2 provided on the rear surface opposite to a lens to display a preview screen. The imaging optical systems 3 may be disposed on the side opposite to the display surface of the display unit 2 to display a face image of an image capturing person on the display screen 1a of the display unit 2. According to the electronic apparatus 1 of the respective embodiments described above, the imaging optical systems 3 are allowed to be disposed in a region overlapping with the display unit 2. Accordingly, the imaging optical systems 3 need not be provided in the bezel portion of the display unit 2, and therefore, the size of the display unit 2 can be enlarged as much as possible.

### (Seventeenth embodiment)

FIG. 38A is a plan view depicting an example where the electronic apparatus 1 of the above embodiments is applied to a head mounted display (hereinafter referred to as an HMD) 61. The HMD 61 depicted in FIG. 38A is used for VR (Virtual Reality), AR (Augmented Reality), MR (Mixed Reality), SR (Substitutional Reality), or the like. An HMD currently available has a camera 62 mounted on an external surface thereof as depicted in FIG. 38B. In this case, a wearer of the HMD is allowed to view a surrounding image. However, there arises such a problem that a surrounding human is unable to recognize the eyes or a facial expression of the wearer of the HMD.

Accordingly, the example depicted in FIG. 38A provides the display surface of the display unit 2 on the external surface of the HMD 61, and the imaging optical systems 3 on the side opposite to the display surface of the display unit 2. In this case, a facial expression produced by the wearer and captured by the imaging optical systems 3 can be displayed on the display surface of the display unit 2. Accordingly, the facial expression or the eye movement of the wearer is recognizable in real time by a human around the wearer.

In the case of FIG. 38A, the imaging optical systems 3 are provided on the rear surface side of the display unit 2. Accordingly, no limitation is imposed on installation positions of the imaging optical systems 3, and therefore, the degree of freedom of designing of the HMD 61 can be raised. Moreover, the camera can be disposed at an optimum position. Accordingly, problems such as deviation of a visual line of the wearer displayed on the display surface are avoidable.

As described above, the electronic apparatus 1 presented in the above embodiments is applicable to various use purposes in the present embodiment. Accordingly, utility values are allowed to increase.

Modes of the present disclosure are not limited to the individual embodiments described above, and also include various modifications which can be conceived of by those skilled in the art. In addition, advantageous effects of the present disclosure are not limited to the contents described above. Specifically, various additions, changes, and partial deletions may be made without departing from the purposes of the present disclosure derived from the contents specified in the claims.

### [Reference Signs List]

1: Electronic apparatus 1a: Display screen
1b: Bezel
2: Display unit
3: Imaging optical system
3A: First imaging optical system
3B: Second imaging optical system
3C: Third imaging optical system
4: Display panel
4a: Substrate
4b: Light emitting pixel
5: Circularly polarizing plate
6: Touch panel
7: Cover glass
8: Imaging unit
8A: First imaging unit
8B: Second imaging unit
9: Optical system
9A: First optical system
9B: Second optical system
10: Preprocessing unit
12: Image acquisition unit
14: Postprocessing unit
16: Output unit
18: Control unit
20: Storage unit
22: Reception interface
30: Light shield
32: Micro-lens array

## Claims

1. An electronic apparatus comprising:
a display unit (2) having a displayable region that includes display optical systems (9) disposed in an array in a first direction and a second direction intersecting the first direction;
a plurality of imaging optical systems (3) that is disposed on a side opposite to a display surface of the display unit and overlapped with the displayable region in a third direction intersecting the first direction and the second direction, and that includes at least a first imaging optical system (3A) and a second imaging optical system (3B) having coordinates different from coordinates of the first imaging optical system in at least one of the first direction and the second direction; and
an image acquisition unit (12) configured to acquire image data on a basis of information acquired by the first imaging optical system and the second imaging optical system, wherein
openings through which light having entered the display unit from the display surface propagates are formed, and
light having entered from the display surface propagates to the imaging optical systems via the openings, **characterized in that**
a layout of the opening through which light propagates to the first imaging optical system is different from a layout of the opening through which light propagates to the second imaging optical system, the layout of the opening including a shape or an orientation of the opening.

2. The electronic apparatus according to claim 1, wherein light propagates from the display surface of the display unit to an imaging element (8A) of the first imaging optical system and an imaging element (8B) of the second imaging optical system via optical systems (9) having different optical characteristics.

3. The electronic apparatus according to claim 1 or 2, further comprising:
a third imaging optical system (3C) that has identical disparity between the first imaging optical system and the third imaging optical system to disparity between the first imaging optical system and the second imaging optical system, wherein
the image acquisition unit (12) is configured to acquire the image data on a basis of information obtained from information acquired by the second imaging optical system and the third imaging optical system, and of information acquired by the first imaging optical system.

4. The electronic apparatus according to claim 3, wherein
the first imaging optical system is provided near a center of the display surface in the first direction or the second direction,
the second imaging optical system and the third imaging optical system are provided near a boundary of the display surface in such a manner that the first imaging optical system is sandwiched between the second imaging optical system and the third imaging optical system in the first direction or the second direction, and
an area that is included in the first imaging optical system and faces the display surface in the third direction is smaller than areas that are included in the second imaging optical system and the third imaging optical system and face the display surface in the third direction.

5. The electronic apparatus according to any one of the preceding claims, wherein
the image acquisition unit is configured to perform image correction by acquiring, in signals output from the first imaging optical system and the second imaging optical system, values of pixels indicating lower light intensity or lower luminance values after conversion into digital signals.

6. The electronic apparatus according to any one of the preceding claims, wherein
which of the first imaging optical system and the second imaging optical system is used with priority, in the case of generation of a flare in any direction, is determined in advance on the basis of a direction of the openings, and,
the image acquisition unit is configured to acquire an imaging result by using the first imaging optical system or the second imaging optical system with priority.

7. The electronic apparatus according to any one of the preceding claims, wherein light shielding (30) is provided between the first imaging optical system and the second imaging optical system.

8. The electronic apparatus according to any one of the preceding claims, wherein the image acquisition unit is configured to merge information acquired by the first imaging optical system and information acquired by the second imaging optical system by using a trained model.

9. The electronic apparatus according to any one of the preceding claims, wherein the image acquisition unit is configured to perform correction in a case where disparity between a plurality of images acquired by a plurality of the imaging optical systems exceeds a predetermined amount.

10. The electronic apparatus according to any one of the preceding claims, wherein at least one of the imaging optical systems includes a micro-lens array.

11. The electronic apparatus according to claim 10, wherein a plurality of the imaging optical systems is provided in a region where the micro-lens array is provided.

12. The electronic apparatus according to any one of the preceding claims, wherein one imaging unit (8) is provided for the first imaging optical system and the second imaging optical system acquire information.

13. The electronic apparatus according to any one of the preceding claims, wherein the display unit includes a plurality of the display optical systems having different optical characteristics.

14. The electronic apparatus according to any one of the preceding claims, wherein at least one of the plurality of the imaging optical systems is configured to be started in a case where signal correction is required in the image acquisition unit.

15. The electronic apparatus according to any one of the preceding claims, wherein the first imaging optical system and the second imaging optical system are integrated into one body.

## Patentansprüche

1. Elektronische Einrichtung, umfassend:
eine Anzeigeeinheit (2), die einen anzeigbaren Bereich aufweist, der optische Anzeigesysteme (9) einschließt, die in einer Anordnung in einer ersten Richtung und einer zweiten Richtung, die die erste Richtung schneidet, eingerichtet sind;
eine Vielzahl von optischen Bildgebungssystemen (3), die auf einer Seite eingerichtet ist, die einer Anzeigeoberfläche der Anzeigeeinheit gegenüberliegt, und die mit dem anzeigbaren Bereich in einer dritten Richtung überlappt, die die erste Richtung und die zweite Richtung schneidet, und die mindestens ein erstes optisches Bildgebungssystem (3A) und ein zweites optisches Bildgebungssystem (3B) einschließt, das Koordinaten aufweist, die sich in mindestens einer der ersten Richtung und der zweiten Richtung von Koordinaten des ersten optischen Bildgebungssystem unterscheiden; und
eine Bilderfassungseinheit (12), die konfiguriert ist, um Bilddaten auf einer Basis von Informationen, die durch das erste optische Bildgebungssystem und das zweite optische Bildgebungssystem erfasst werden, zu erfassen, wobei
Öffnungen ausgebildet werden, durch die sich Licht, das von der Anzeigeoberfläche in die Anzeigeeinheit eingedrungen ist, ausbreitet, und
sich Licht, das von der Anzeigeoberfläche eingedrungen ist, über die Öffnungen zu den optischen Bildgebungssystemen ausbreitet,
**dadurch gekennzeichnet, dass**
ein Entwurf der Öffnung, durch die sich Licht zu dem ersten optischen Bildgebungssystem ausbreitet, sich von einem Entwurf der Öffnung unterscheidet, durch die sich Licht zu dem zweiten optischen Bildgebungssystem ausbreitet, wobei der Entwurf der Öffnung eine Form oder eine Ausrichtung der Öffnung einschließt.

2. Elektronische Einrichtung nach Anspruch 1, wobei sich Licht von der Anzeigeoberfläche der Anzeigeeinheit über optische Systeme (9), die unterschiedliche optische Eigenschaften aufweisen, zu einem Bildgebungselement (8A) des ersten optischen Bildgebungssystems und einem Bildgebungselement (8B) des zweiten optischen Bildgebungssystems ausbreitet.

3. Elektronische Einrichtung nach Anspruch 1 oder 2, ferner umfassend:
ein drittes optisches Bildgebungssystem (3C), das eine identische Ungleichheit zwischen dem ersten optischen Bildgebungssystem und dem dritten optischen Bildgebungssystem zu der Ungleichheit zwischen dem ersten optischen Bildgebungssystem und dem zweiten optischen Bildgebungssystem aufweist, wobei
die Bilderfassungseinheit (12) konfiguriert ist, um die Bilddaten auf einer Basis von Informationen, die aus Informationen erhalten werden, die durch das zweite optischen Bildgebungssystem und das dritte optischen Bildgebungssystem erfasst werden, und von Informationen zu erfassen, die durch das erste optische Bildgebungssystem erfasst werden.

4. Elektronische Einrichtung nach Anspruch 3, wobei
das erste optische Bildgebungssystem in der Nähe eines Mittelpunkts der Anzeigeoberfläche in der ersten Richtung oder der zweiten Richtung bereitgestellt ist,
das zweite optische Bildgebungssystem und das dritte optische Bildgebungssystem in der Nähe einer Grenze der Anzeigeoberfläche derart bereitgestellt sind, dass das erste optische Bildgebungssystem in der ersten Richtung oder der zweiten Richtung zwischen dem zweiten optischen Bildgebungssystem und dem dritten optischen Bildgebungssystem gelegen ist, und
eine Fläche, die in dem ersten optischen Bildgebungssystem eingeschlossen ist und der Anzeigeoberfläche in der dritten Richtung zugewandt ist, kleiner ist als Flächen, die in dem zweiten optischen Bildgebungssystem und dem dritten optischen Bildgebungssystem eingeschlossen sind und der Anzeigeoberfläche in der dritten Richtung zugewandt sind.

5. Elektronische Einrichtung nach einem der vorstehenden Ansprüche, wobei
die Bilderfassungseinheit konfiguriert ist, um eine Bildkorrektur durchzuführen, durch Erfassen, in Signalen, die durch das erste optische Bildgebungssystem und das zweite optische Bildgebungssystem ausgegeben werden, von Werten von Pixeln, die nach einer Umwandlung in digitale Signale eine geringere Lichtintensität oder geringere Luminanzwerte angeben.

6. Elektronische Einrichtung nach einem der vorstehenden Ansprüche, wobei
welches des ersten optischen Bildgebungssystems und des zweiten optischen Bildgebungssystems im Falle der Erzeugung eines Streulichts in einer beliebigen Richtung vorrangig verwendet wird im Voraus auf der Basis einer Richtung der Öffnungen bestimmt wird, und
die Bilderfassungseinheit konfiguriert ist, um ein Bildgebungsergebnis durch vorrangiges Verwenden des ersten optischen Bildgebungssystems oder des zweiten optischen Bildgebungssystems zu erfassen.

7. Elektronische Einrichtung nach einem der vorstehenden Ansprüche, wobei zwischen dem ersten optischen Bildgebungssystem und dem zweiten optischen Bildgebungssystem eine Lichtabschirmung (30) bereitgestellt ist.

8. Elektronische Einrichtung nach einem der vorstehenden Ansprüche, wobei die Bilderfassungseinheit konfiguriert ist, um Informationen, die durch das erste optische Bildgebungssystem erfasst werden, und Informationen, die durch das zweite optische Bildgebungssystem erfasst werden, durch Verwenden eines trainierten Modells zusammenzuführen.

9. Elektronische Einrichtung nach einem der vorstehenden Ansprüche, wobei die Bilderfassungseinheit konfiguriert ist, um, in einem Fall, in dem eine Ungleichheit zwischen einer Vielzahl von Bildern, die durch eine Vielzahl von optischen Bildgebungssystemen erfasst wird, einen zuvor bestimmten Betrag überschreitet, die Korrektur durchzuführen.

10. Elektronische Einrichtung nach einem der vorstehenden Ansprüche, wobei mindestens eines der optischen Bildgebungssysteme eine Mikrolinsenanordnung einschließt.

11. Elektronische Einrichtung nach Anspruch 10, wobei eine Vielzahl der optischen Bildgebungssysteme in einem Bereich bereitgestellt ist, in dem die Mikrolinsenanordnung bereitgestellt ist.

12. Elektronische Einrichtung nach einem der vorstehenden Ansprüche, wobei eine Bildgebungseinheit (8) bereitgestellt ist, damit das erste optische Bildgebungssystem und das zweite optische Bildgebungssystem Informationen erfasst.

13. Elektronische Einrichtung nach einem der vorstehenden Ansprüche, wobei die Anzeigeeinheit eine Vielzahl der optischen Anzeigesysteme, die unterschiedliche optische Eigenschaften aufweist, einschließt.

14. Elektronische Einrichtung nach einem der vorstehenden Ansprüche, wobei mindestens eines der Vielzahl der optischen Bildgebungssysteme konfiguriert ist, um, in einem Fall, in dem die Signalkorrektur in der Bilderfassungseinheit erforderlich ist, gestartet zu werden.

15. Elektronische Einrichtung nach einem der vorstehenden Ansprüche, wobei das erste optische Bildgebungssystem und das zweite optische Bildgebungssystem in einen Körper integriert sind.

## Revendications

1. Appareil électronique comprenant :
une unité d'affichage (2) ayant une région affichable qui comporte des systèmes optiques d'affichage (9) disposés dans un réseau dans une première direction et une deuxième direction croisant la première direction ;
une pluralité de systèmes optiques d'imagerie (3) qui est disposée sur un côté opposé à une surface d'affichage de l'unité d'affichage et chevauchée par la région affichable dans une troisième direction croisant la première direction et la deuxième direction, et qui comporte au moins un premier système optique d'imagerie (3A) et un deuxième système optique d'imagerie (3B) ayant des coordonnées différentes des coordonnées du premier système optique d'imagerie dans au moins l'une parmi la première direction et la deuxième direction ; et
une unité d'acquisition d'image (12) configurée pour acquérir des données d'image en fonction d'informations acquises par le premier système optique d'imagerie et le deuxième système optique d'imagerie, dans lequel
des ouvertures à travers lesquelles de la lumière ayant pénétré dans l'unité d'affichage à partir de la surface d'affichage se propage sont formées, et
de la lumière ayant pénétré à partir de la surface d'affichage se propage vers les systèmes optiques d'imagerie par l'intermédiaire des ouvertures,
**caractérisé en ce que**
une disposition de l'ouverture à travers laquelle la lumière se propage vers le premier système optique d'imagerie est différente d'une disposition de l'ouverture à travers laquelle la lumière se propage vers le deuxième système optique d'imagerie, la disposition de l'ouverture comportant une forme ou une orientation de l'ouverture.

2. Appareil électronique selon la revendication 1, dans lequel de la lumière se propage à partir de la surface d'affichage de l'unité d'affichage vers un élément d'imagerie (8A) du premier système optique d'imagerie et un élément d'imagerie (8B) du deuxième système optique d'imagerie par l'intermédiaire de systèmes optiques (9) ayant des caractéristiques optiques différentes.

3. Appareil électronique selon la revendication 1 ou 2, comprenant en outre :
un troisième système optique d'imagerie (3C) qui a une disparité entre le premier système optique d'imagerie et le troisième système optique d'imagerie identique à une disparité entre le premier système optique d'imagerie et le deuxième système optique d'imagerie, dans lequel
l'unité d'acquisition d'image (12) est configurée pour acquérir les données d'image en fonction d'informations obtenues à partir d'informations acquises par le deuxième système optique d'imagerie et le troisième système optique d'imagerie, et d'informations acquises par le premier système optique d'imagerie.

4. Appareil électronique selon la revendication 3, dans lequel
le premier système optique d'imagerie est fourni près d'un centre de la surface d'affichage dans la première direction ou la deuxième direction,
le deuxième système optique d'imagerie et le troisième système optique d'imagerie sont fournis près d'une limite de la surface d'affichage d'une manière telle que le premier système optique d'imagerie est placé en sandwich entre le deuxième système optique d'imagerie et le troisième système optique d'imagerie dans la première direction ou la deuxième direction, et
une zone qui est incluse dans le premier système optique d'imagerie et fait face vers la surface d'affichage dans la troisième direction est plus petite que des zones qui sont incluses dans le deuxième système optique d'imagerie et le troisième système optique d'imagerie et font face vers la surface d'affichage dans la troisième direction.

5. Appareil électronique selon l'une quelconque des revendications précédentes, dans lequel
l'unité d'acquisition d'image est configurée pour mettre en oeuvre une correction d'image par acquisition, dans des signaux délivrés en sortie par le premier système optique d'imagerie et le deuxième système optique d'imagerie, de valeurs de pixels indiquant une intensité de lumière plus basse ou des valeurs de luminance plus basses après conversion en signaux numériques.

6. Appareil électronique selon l'une quelconque des revendications précédentes, dans lequel
celui du premier système optique d'imagerie et du deuxième système optique d'imagerie qui est utilisé en priorité, dans le cas de génération d'une lumière parasite dans l'une quelconque direction, est déterminé à l'avance en fonction d'une direction des ouvertures, et,
l'unité d'acquisition d'image est configurée pour acquérir un résultat d'imagerie en utilisant le premier système optique d'imagerie ou le deuxième système optique d'imagerie en priorité.

7. Appareil électronique selon l'une quelconque des revendications précédentes, dans lequel un masquage de lumière (30) est fourni entre le premier système optique d'imagerie et le deuxième système optique d'imagerie.

8. Appareil électronique selon l'une quelconque des revendications précédentes, dans lequel l'unité d'acquisition d'image est configurée pour fusionner des informations acquises par le premier système optique d'imagerie et des informations acquises par le deuxième système optique d'imagerie en utilisant un modèle entraîné.

9. Appareil électronique selon l'une quelconque des revendications précédentes, dans lequel l'unité d'acquisition d'image est configurée pour mettre en oeuvre une correction dans un cas où une disparité entre une pluralité d'images acquises par une pluralité des systèmes optiques d'imagerie dépasse une quantité prédéterm inée.

10. Appareil électronique selon l'une quelconque des revendications précédentes, dans lequel au moins l'un des systèmes optiques d'imagerie comporte un réseau de micro-lentilles.

11. Appareil électronique selon la revendication 10, dans lequel une pluralité des systèmes optiques d'imagerie est fournie dans une région où le réseau de micro-lentilles est fourni.

12. Appareil électronique selon l'une quelconque des revendications précédentes, dans lequel une unité d'imagerie (8) est fournie pour permettre au premier système optique d'imagerie et au deuxième système optique d'imagerie d'acquérir des informations.

13. Appareil électronique selon l'une quelconque des revendications précédentes, dans lequel l'unité d'affichage comporte une pluralité des systèmes optiques d'affichage ayant des caractéristiques optiques différentes.

14. Appareil électronique selon l'une quelconque des revendications précédentes, dans lequel au moins l'un parmi la pluralité des systèmes optiques d'imagerie est conçu pour être démarré dans un cas où une correction de signal est requise dans l'unité d'acquisition d'image.

15. Appareil électronique selon l'une quelconque des revendications précédentes, dans lequel le premier système optique d'imagerie et le deuxième système optique d'imagerie sont intégrés dans un corps.
